(19) **Europäisches Patentamt / European Patent Office / Office européen des brevets**

(11) **EP 4 614 973 A1**

(12) **EUROPEAN PATENT APPLICATION**

(43) Date of publication:
**10.09.2025   Bulletin 2025/37**

(21) Application number: **24305345.1**

(22) Date of filing: **06.03.2024**

(51) International Patent Classification (IPC):
**H04N 19/13** $^{(2014.01)}$    **H03M 7/40** $^{(2006.01)}$
**H04N 19/184** $^{(2014.01)}$    **H04N 19/91** $^{(2014.01)}$

(52) Cooperative Patent Classification (CPC):
**H04N 19/13; H03M 7/4018; H04N 19/184; H04N 19/91**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **InterDigital CE Patent Holdings, SAS 75017 Paris (FR)**

(72) Inventors:
• **GALPIN, Franck 35235 THORIGNE-FOUILLARD (FR)**
• **LO BIANCO, Federico 35700 RENNES (FR)**
• **SALMON-LEGAGNEUR, Charles 35000 RENNES (FR)**
• **BALCILAR, Muhammet 35830 BETTON (FR)**

(74) Representative: **Rittner, Karsten Rittner & Partner Patentanwälte mbB Schiffgraben 17 30159 Hannover (DE)**

(54) **NABAC AND MULTI-MODELS OPTIMIZATION**

(57)     Systems, methods, and instrumentalities are disclosed for dynamically selecting and/or signaling a choice of syntax element distribution model. For example, syntax elements may be encoded based on a context-adaptive binary arithmetic coding (CABAC) context, an NABAC context, or a context adaptive equi-probable (EP) coding context. A device (e.g., a decoder) may entropy decode a syntax element. The syntax element may comprise bits coded in corresponding bins. The decoder may determine the bit count associated with the syntax element (e.g., the number of bits that comprise the syntax element). The device may determine a context associated with the most significant bit (MSB) of the syntax element based on the bit count. The device may entropy decode the syntax element based on the determined context associated with the MSB.

**EP 4 614 973 A1**

**FIG. 10**

## Description

### BACKGROUND

Video coding systems may be used to compress digital video signals, e.g., to reduce the storage and/or transmission bandwidth needed for such signals. Video coding systems may include, for example, block-based, wavelet-based, and/or object-based systems.

### SUMMARY

Systems, methods, and instrumentalities are disclosed for dynamically selecting and/or signaling a choice of syntax element distribution model. For example, syntax elements may be encoded based on a context-adaptive binary arithmetic coding (CABAC) context, an NABAC context, or an equi-probable (EP) context.

A bin may be processed according to an associated context. The associated context may identify the video bin. The associated context may comprise a plurality of model parameters that represent a result of a training strategy. The training strategy may include optimizing a cost function over the plurality of model parameters, for example to minimize a total cost of encoded bits and/or a ratio a cost associated with a bit to a bitstream size.

A device (e.g., a decoder) may entropy decode a syntax element. The syntax element may comprise bits coded in corresponding bins. The decoder may determine the bit count associated with the syntax element (e.g., the number of bits that comprise the syntax element). The device may determine a context associated with the most significant bit (MSB) of the syntax element based on the bit count. The device may entropy decode the syntax element based on the determined context associated with the MSB.

Each of the bins associated with the syntax element may be associated with a respective context (e.g., of contexts associated with the syntax element). The device may determine the context associated with the MSB of the syntax element based on the bit count in the syntax element, such as using the last context of the plurality of contexts associated with the syntax element. For example, the device may identify the last context based on the bit count. The device may associate the last context of the plurality of contexts with the MSB of the syntax element. The device may entropy decode the bin corresponding to the MSB of the syntax element based on the identified context associated with the MSB.

The device may identify, for example based on the bit count in the syntax element, the second-to-last context (e.g., of the contexts associated with the syntax element, such as context(N-2)). The device may associate the second-to-last context with a second MSB of the syntax element (e.g., such that the N-1th bit is associated with context(N-2)). The device may entropy decode a bin corresponding to the second MSB of the syntax element based on the identified second-to-last context associated with the second MSB of the syntax element.

The device may identify the first context of the contexts associated with the syntax element. The device may associate the first context of the plurality of contexts with a least significant bit (LSB) of the syntax element. The device may entropy decode a bin corresponding to the LSB of the syntax element based on the identified first context associated with the LSB of the syntax element.

The device may determine, based on the context associated with the MSB, an entropy coding model for decoding the MSB of the syntax element. The entropy coding model may be one of context adaptive binary arithmetic coding (CABAC), non-adaptive binary arithmetic coding (NABAC), or equal probability coding.

The syntax element may comprise an additional bit associated with truncated binarization. The device may identify the first context of the contexts associated with the syntax element (e.g., context(0)). The device may associate the first context of the plurality of contexts with the additional bit. The device may entropy decode a bin corresponding to the additional bit based on the identified first context associated with the additional bit.

The device may identify the context associated with the MSB based on a determination that the syntax element is encoded using direct binarization.

In examples, a syntax element may comprise N bits that are associated with N contexts. For example, the MSB (e.g., the Nth bit) may be associated with the context(N-1) and/or the least significant bit (e.g., the first bit) may be associated with the context(0). Decoding the syntax element based on the context associated with the MSB may comprise decoding the bits using an order (e.g., processing order, decoding order) based on the corresponding context of each bit. For example, the decoding order may begin with the context associated with the MSB and/or may end with a context associated with a least significant bit (LSB). The order of entropy coding may be relevant as each bin may be (e.g., must be) decoded serially. The binarization, for example MSB decoded first, may allow for backward compatibility (e.g., the context is in a reverse order of the bits in case the bit count changes).

A device (e.g., an encoder) may determine a syntax element. The syntax element may have a plurality of bits. The device may determine, for each bit in the syntax element, an associated context (e.g., each bit may be associated with a respective context). The device may entropy encode, based on the context associated with each bit in the plurality of bits, the syntax element in a plurality of bins.

The context associated with a most significant bit (MSB) may be associated with an entropy coding model used for encoding the syntax element. For example, the entropy coding model may be one of context adaptive binary arithmetic coding (CABAC), non-adaptive binary arithmetic coding (NABAC) or context adaptive equal probability coding.

The number of bits may comprise a prefix associated with a first portion of the number of bits and a first context, and a suffix code associated with a second portion of the number of bits and a second context.

In examples, video may be entropy decoded by performing one or more of the following. A device (e.g., a decoding device) may obtain a syntax element. The syntax element may comprise a plurality of prefix bits associated with a plurality of contexts in a first set of contexts and a plurality of suffix bits associated with a plurality of contexts in a second set of contexts. The device may entropy decode the plurality of prefix bits using a first entropy coding model (e.g., unary coding). The device may entropy decode the plurality of prefix bits based on the plurality of contexts in the first set of contexts. The device may entropy decode the plurality of suffix bits using a second entropy coding model (e.g., direct binarization, for example where a bit count may dynamically change depending on the prefix). The device may entropy decode the plurality of suffix bits based on the plurality of contexts in the second set of contexts.

Systems, methods, and instrumentalities described herein may involve a decoder. In some examples, the systems, methods, and instrumentalities described herein may involve an encoder. In some examples, the systems, methods, and instrumentalities described herein may involve a signal (e.g., from an encoder and/or received by a decoder). A computer-readable medium may include instructions for causing one or more processors to perform methods described herein. A computer program product may include instructions which, when the program is executed by one or more processors, may cause the one or more processors to carry out the methods described herein.

## BRIEF DESCRIPTION OF THE DRAWINGS

FIG. 1A is a system diagram illustrating an example communications system in which one or more disclosed embodiments may be implemented.

FIG. 1B is a system diagram illustrating an example wireless transmit/receive unit (WTRU) that may be used within the communications system illustrated in FIG. 1A according to an embodiment.

FIG. 1C is a system diagram illustrating an example radio access network (RAN) and an example core network (CN) that may be used within the communications system illustrated in FIG. 1A according to an embodiment.

FIG. 1D is a system diagram illustrating a further example RAN and a further example CN that may be used within the communications system illustrated in FIG. 1A according to an embodiment.

FIG. 2 illustrates an example video encoder.

FIG. 3 illustrates an example video decoder.

FIG. 4 illustrates an example of a a system in which various aspects and examples may be implemented.

FIG. 5 depicts an example of entropy coding by a video codec.

FIG. 6 depicts example parameter initialization at the beginning of a slice.

FIG. 7 illustrates an example of a context adaptive binary arithmetic coding (CABAC) engine.

FIG. 8 illustrates a flowchart showing an example for decoding a (e.g., single) binary decision.

FIG. 9 depicts an example syntax element coding workflow.

FIG. 10 depicts an example adapted syntax element coding workflow.

## DETAILED DESCRIPTION

A more detailed understanding may be had from the following description, given by way of example in conjunction with the accompanying drawings.

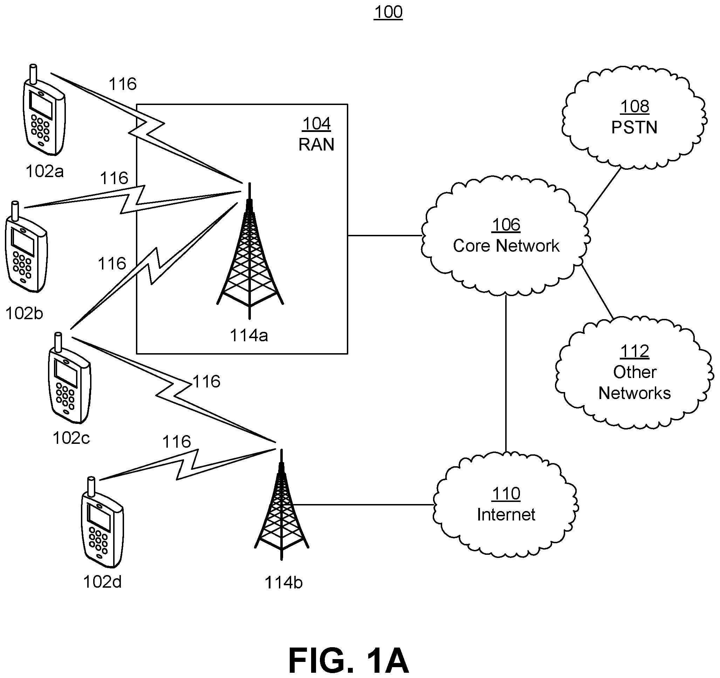

FIG. 1A is a diagram illustrating an example communications system 100 in which one or more disclosed embodiments may be implemented. The communications system 100 may be a multiple access system that provides content, such as voice, data, video, messaging, broadcast, etc., to multiple wireless users. The communications system 100 may enable multiple wireless users to access such content through the sharing of system resources, including wireless bandwidth. For example, the communications systems 100 may employ one or more channel access methods, such as code division multiple access (CDMA), time division multiple access (TDMA), frequency division multiple access (FDMA), orthogonal FDMA (OFDMA), single-carrier FDMA (SC-FDMA), zero-tail unique-word DFT-Spread OFDM (ZT UW DTS-s OFDM), unique word OFDM (UW-OFDM), resource block-filtered OFDM, filter bank multicarrier (FBMC), and the like.

As shown in FIG. 1A, the communications system 100 may include wireless transmit/receive units (WTRUs) 102a, 102b, 102c, 102d, a RAN 104/113, a CN 106/115, a public switched telephone network (PSTN) 108, the Internet 110, and other networks 112, though it will be appreciated that the disclosed embodiments contemplate any number of WTRUs, base stations, networks, and/or network elements. Each of the WTRUs 102a, 102b, 102c, 102d may be any type of device configured to operate and/or communicate in a wireless environment. By way of example, the WTRUs 102a, 102b, 102c, 102d, any of which may be referred to as a "station" and/or a "STA", may be configured to transmit and/or receive wireless signals and may include a user equipment (UE), a mobile station, a fixed or mobile subscriber unit, a subscription-based unit, a pager, a cellular telephone, a personal digital assistant (PDA), a smartphone, a laptop, a netbook, a personal computer, a wireless sensor, a hotspot or Mi-Fi device, an Internet of Things (IoT) device, a watch or other wearable, a head-mounted display (HMD), a vehicle, a drone, a medical device and applications (e.g., remote surgery), an industrial device and applications (e.g., a robot and/or other wireless devices operating in an industrial and/or an automated processing chain contexts), a consumer electronics device, a device operating on commercial and/or industrial wireless networks, and the like. Any of the WTRUs 102a, 102b, 102c and 102d may be interchangeably referred to as a UE.

The communications systems 100 may also include a base station 114a and/or a base station 114b. Each of the base stations 114a, 114b may be any type of device configured to wirelessly interface with at least one of the WTRUs 102a, 102b, 102c, 102d to facilitate access to one or more communication networks, such as the CN 106/115, the Internet 110, and/or the other networks 112. By way of example, the base stations 114a, 114b may be a base transceiver station (BTS), a Node-B, an eNode B, a Home Node B, a Home eNode B, a gNB, a NR NodeB, a site controller, an access point (AP), a wireless router, and the like. While the base stations 114a, 114b are each depicted as a single element, it will be appreciated that the base stations 114a, 114b may include any number of interconnected base stations and/or network elements.

The base station 114a may be part of the RAN 104/113, which may also include other base stations and/or network elements (not shown), such as a base station controller (BSC), a radio network controller (RNC), relay nodes, etc. The base station 114a and/or the base station 114b may be configured to transmit and/or receive wireless signals on one or more carrier frequencies, which may be referred to as a cell (not shown). These frequencies may be in licensed spectrum, unlicensed spectrum, or a combination of licensed and unlicensed spectrum. A cell may provide coverage for a wireless service to a specific geographical area that may be relatively fixed or that may change over time. The cell may further be divided into cell sectors. For example, the cell associated with the base station 114a may be divided into three sectors. Thus, in one embodiment, the base station 114a may include three transceivers, i.e., one for each sector of the cell. In an embodiment, the base station 114a may employ multiple-input multiple output (MIMO) technology and may utilize multiple transceivers for each sector of the cell. For example, beamforming may be used to transmit and/or receive signals in desired spatial directions.

The base stations 114a, 114b may communicate with one or more of the WTRUs 102a, 102b, 102c, 102d over an air interface 116, which may be any suitable wireless communication link (e.g., radio frequency (RF), microwave, centimeter wave, micrometer wave, infrared (IR), ultraviolet (UV), visible light, etc.). The air interface 116 may be established using any suitable radio access technology (RAT).

More specifically, as noted above, the communications system 100 may be a multiple access system and may employ one or more channel access schemes, such as CDMA, TDMA, FDMA, OFDMA, SC-FDMA, and the like. For example, the base station 114a in the RAN 104/113 and the WTRUs 102a, 102b, 102c may implement a radio technology such as Universal Mobile Telecommunications System (UMTS) Terrestrial Radio Access (UTRA), which may establish the air interface 115/116/117 using wideband CDMA (WCDMA). WCDMA may include communication protocols such as High-Speed Packet Access (HSPA) and/or Evolved HSPA (HSPA+). HSPA may include High-Speed Downlink (DL) Packet Access (HSDPA) and/or High-Speed UL Packet Access (HSUPA).

In an embodiment, the base station 114a and the WTRUs 102a, 102b, 102c may implement a radio technology such as Evolved UMTS Terrestrial Radio Access (E-UTRA), which may establish the air interface 116 using Long Term Evolution (LTE) and/or LTE-Advanced (LTE-A) and/or LTE-Advanced Pro (LTE-A Pro).

In an embodiment, the base station 114a and the WTRUs 102a, 102b, 102c may implement a radio technology such as NR Radio Access, which may establish the air interface 116 using New Radio (NR).

In an embodiment, the base station 114a and the WTRUs 102a, 102b, 102c may implement multiple radio access technologies. For example, the base station 114a and the WTRUs 102a, 102b, 102c may implement LTE radio access and NR radio access together, for instance using dual connectivity (DC) principles. Thus, the air interface utilized by WTRUs 102a, 102b, 102c may be characterized by multiple types of radio access technologies and/or transmissions sent to/from multiple types of base stations (e.g., a eNB and a gNB).

In other embodiments, the base station 114a and the WTRUs 102a, 102b, 102c may implement radio technologies such as IEEE 802.11 (i.e., Wireless Fidelity (WiFi), IEEE 802.16 (i.e., Worldwide Interoperability for Microwave Access (WiMAX)), CDMA2000, CDMA2000 1X, CDMA2000 EV-DO, Interim Standard 2000 (IS-2000), Interim Standard 95 (IS-95), Interim Standard 856 (IS-856), Global System for Mobile communications (GSM), Enhanced Data rates for GSM Evolution (EDGE), GSM EDGE (GERAN), and the like.

The base station 114b in FIG. 1A may be a wireless router, Home Node B, Home eNode B, or access point, for example, and may utilize any suitable RAT for facilitating wireless connectivity in a localized area, such as a place of business, a home, a vehicle, a campus, an industrial facility, an air corridor (e.g., for use by drones), a roadway, and the like. In one embodiment, the base station 114b and the WTRUs 102c, 102d may implement a radio technology such as IEEE 802.11 to establish a wireless local area network (WLAN). In an embodiment, the base station 114b and the WTRUs 102c, 102d may implement a radio technology such as IEEE 802.15 to establish a wireless personal area network (WPAN). In yet another embodiment, the base station 114b and the WTRUs 102c, 102d may utilize a cellular-based RAT (e.g., WCDMA, CDMA2000, GSM, LTE, LTE-A, LTE-A Pro, NR etc.) to establish a picocell or femtocell. As shown in FIG. 1A, the base station 114b may have a direct connection to the Internet 110. Thus, the base station 114b may not be required to access the Internet 110 via the CN 106/115.

The RAN 104/113 may be in communication with the CN 106/115, which may be any type of network configured to provide voice, data, applications, and/or voice over internet protocol (VoIP) services to one or more of the WTRUs 102a, 102b, 102c, 102d. The data may have varying quality of service (QoS) requirements, such as differing throughput requirements, latency requirements, error tolerance requirements, reliability requirements, data throughput requirements, mobility requirements, and the like. The CN 106/115 may provide call control, billing services, mobile location-based services, pre-paid calling, Internet connectivity, video distribution, etc., and/or perform high-level security functions, such as user authentication. Although not shown in FIG. 1A, it will be appreciated that the RAN 104/113 and/or the CN 106/115 may be in direct or indirect communication with other RANs that employ the same RAT as the RAN 104/113 or a different RAT. For example, in addition to being connected to the RAN 104/113, which may be utilizing a NR radio technology, the CN 106/115 may also be in communication with another RAN (not shown) employing a GSM, UMTS, CDMA 2000, WiMAX, E-UTRA, or WiFi radio technology.

The CN 106/115 may also serve as a gateway for the WTRUs 102a, 102b, 102c, 102d to access the PSTN 108, the Internet 110, and/or the other networks 112. The PSTN 108 may include circuit-switched telephone networks that provide plain old telephone service (POTS). The Internet 110 may include a global system of interconnected computer networks and devices that use common communication protocols, such as the transmission control protocol (TCP), user datagram protocol (UDP) and/or the internet protocol (IP) in the TCP/IP internet protocol suite. The networks 112 may include wired and/or wireless communications networks owned and/or operated by other service providers. For example, the networks 112 may include another CN connected to one or more RANs, which may employ the same RAT as the RAN 104/113 or a different RAT.

Some or all of the WTRUs 102a, 102b, 102c, 102d in the communications system 100 may include multi-mode capabilities (e.g., the WTRUs 102a, 102b, 102c, 102d may include multiple transceivers for communicating with different wireless networks over different wireless links). For example, the WTRU 102c shown in FIG. 1A may be configured to communicate with the base station 114a, which may employ a cellular-based radio technology, and with the base station 114b, which may employ an IEEE 802 radio technology.

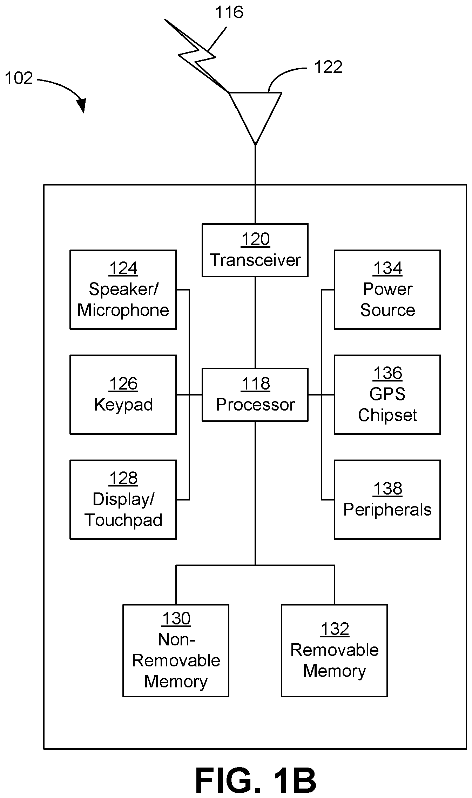

FIG. 1B is a system diagram illustrating an example WTRU 102. As shown in FIG. 1B, the WTRU 102 may include a processor 118, a transceiver 120, a transmit/receive element 122, a speaker/microphone 124, a keypad 126, a display/touchpad 128, non-removable memory 130, removable memory 132, a power source 134, a global positioning system (GPS) chipset 136, and/or other peripherals 138, among others. It will be appreciated that the WTRU 102 may include any sub-combination of the foregoing elements while remaining consistent with an embodiment.

The processor 118 may be a general purpose processor, a special purpose processor, a conventional processor, a digital signal processor (DSP), a plurality of microprocessors, one or more microprocessors in association with a DSP core, a controller, a microcontroller, Application Specific Integrated Circuits (ASICs), Field Programmable Gate Arrays (FPGAs) circuits, any other type of integrated circuit (IC), a state machine, and the like. The processor 118 may perform signal coding, data processing, power control, input/output processing, and/or any other functionality that enables the WTRU 102 to operate in a wireless environment. The processor 118 may be coupled to the transceiver 120, which may be coupled to the transmit/receive element 122. While FIG. 1B depicts the processor 118 and the transceiver 120 as separate components, it will be appreciated that the processor 118 and the transceiver 120 may be integrated together in an electronic package or chip.

The transmit/receive element 122 may be configured to transmit signals to, or receive signals from, a base station (e.g., the base station 114a) over the air interface 116. For example, in one embodiment, the transmit/receive element 122 may be an antenna configured to transmit and/or receive RF signals. In an embodiment, the transmit/receive element 122 may be an emitter/detector configured to transmit and/or receive IR, UV, or visible light signals, for example. In yet another embodiment, the transmit/receive element 122 may be configured to transmit and/or receive both RF and light signals. It will be appreciated that the transmit/receive element 122 may be configured to transmit and/or receive any combination of wireless signals.

Although the transmit/receive element 122 is depicted in FIG. 1B as a single element, the VIΓΓRU 102 may include any number of transmit/receive elements 122. More specifically, the WTRU 102 may employ MIMO technology. Thus, in one embodiment, the WTRU 102 may include two or more transmit/receive elements 122 (e.g., multiple antennas) for transmitting and receiving wireless signals over the air interface 116.

The transceiver 120 may be configured to modulate the signals that are to be transmitted by the transmit/receive element 122 and to demodulate the signals that are received by the transmit/receive element 122. As noted above, the WTRU 102 may have multi-mode capabilities. Thus, the transceiver 120 may include multiple transceivers for enabling the WTRU 102 to communicate via multiple RATs, such as NR and IEEE 802.11, for example.

The processor 118 of the WTRU 102 may be coupled to, and may receive user input data from, the speaker/microphone 124, the keypad 126, and/or the display/touchpad 128 (e.g., a liquid crystal display (LCD) display unit or organic light-emitting diode (OLED) display unit). The processor 118 may also output user data to the speaker/microphone 124, the keypad 126, and/or the display/touchpad 128. In addition, the processor 118 may access information from, and store data in, any type of suitable memory, such as the non-removable memory 130 and/or the removable memory 132. The non-removable memory 130 may include random-access memory (RAM), read-only memory (ROM), a hard disk, or any other type of memory storage device. The removable memory 132 may include a subscriber identity module (SIM) card, a memory stick, a secure digital (SD) memory card, and the like. In other embodiments, the processor 118 may access information from, and store data in, memory that is not physically located on the WTRU 102, such as on a server or a home computer (not shown).

The processor 118 may receive power from the power source 134, and may be configured to distribute and/or control the power to the other components in the WTRU 102. The power source 134 may be any suitable device for powering the WTRU 102. For example, the power source 134 may include one or more dry cell batteries (e.g., nickel-cadmium (NiCd), nickel-zinc (NiZn), nickel metal hydride (NiMH), lithium-ion (Li-ion), etc.), solar cells, fuel cells, and the like.

The processor 118 may also be coupled to the GPS chipset 136, which may be configured to provide location information (e.g., longitude and latitude) regarding the current location of the WTRU 102. In addition to, or in lieu of, the information from the GPS chipset 136, the WTRU 102 may receive location information over the air interface 116 from a base station (e.g., base stations 114a, 114b) and/or determine its location based on the timing of the signals being received from two or more nearby base stations. It will be appreciated that the WTRU 102 may acquire location information by way of any suitable location-determination method while remaining consistent with an embodiment.

The processor 118 may further be coupled to other peripherals 138, which may include one or more software and/or hardware modules that provide additional features, functionality and/or wired or wireless connectivity. For example, the peripherals 138 may include an accelerometer, an e-compass, a satellite transceiver, a digital camera (for photographs and/or video), a universal serial bus (USB) port, a vibration device, a television transceiver, a hands free headset, a Bluetooth® module, a frequency modulated (FM) radio unit, a digital music player, a media player, a video game player module, an Internet browser, a Virtual Reality and/or Augmented Reality (VR/AR) device, an activity tracker, and the like. The peripherals 138 may include one or more sensors, the sensors may be one or more of a gyroscope, an accelerometer, a hall effect sensor, a magnetometer, an orientation sensor, a proximity sensor, a temperature sensor, a time sensor; a geolocation sensor; an altimeter, a light sensor, a touch sensor, a magnetometer, a barometer, a gesture sensor, a biometric sensor, and/or a humidity sensor.

The VIΓΓRU 102 may include a full duplex radio for which transmission and reception of some or all of the signals (e.g., associated with particular subframes for both the UL (e.g., for transmission) and downlink (e.g., for reception) may be concurrent and/or simultaneous. The full duplex radio may include an interference management unit to reduce and or substantially eliminate self-interference via either hardware (e.g., a choke) or signal processing via a processor (e.g., a separate processor (not shown) or via processor 118). In an embodiment, the WRTU 102 may include a half-duplex radio for which transmission and reception of some or all of the signals (e.g., associated with particular subframes for either the UL (e.g., for transmission) or the downlink (e.g., for reception)).

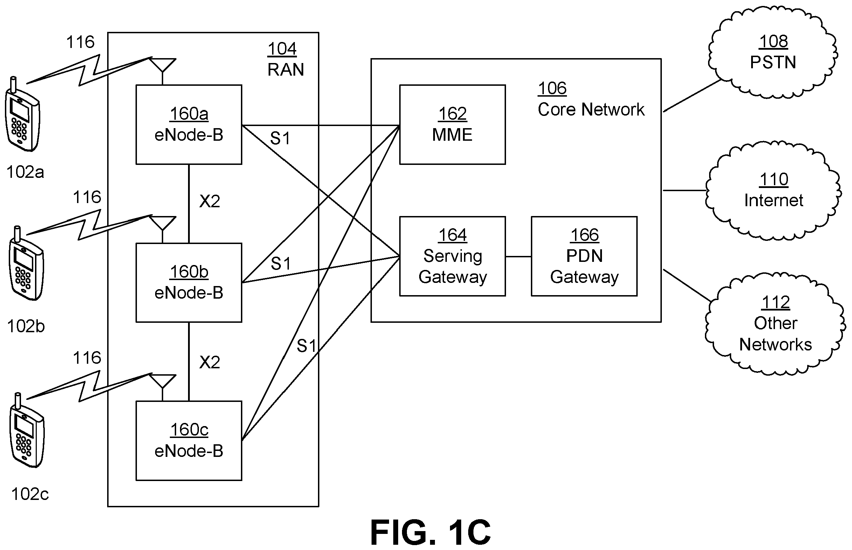

FIG. 1C is a system diagram illustrating the RAN 104 and the CN 106 according to an embodiment. As noted above, the RAN 104 may employ an E-UTRA radio technology to communicate with the WTRUs 102a, 102b, 102c over the air interface 116. The RAN 104 may also be in communication with the CN 106.

The RAN 104 may include eNode-Bs 160a, 160b, 160c, though it will be appreciated that the RAN 104 may include any number of eNode-Bs while remaining consistent with an embodiment. The eNode-Bs 160a, 160b, 160c may each include one or more transceivers for communicating with the WTRUs 102a, 102b, 102c over the air interface 116. In one embodiment, the eNode-Bs 160a, 160b, 160c may implement MIMO technology. Thus, the eNode-B 160a, for example, may use multiple antennas to transmit wireless signals to, and/or receive wireless signals from, the WTRU 102a.

Each of the eNode-Bs 160a, 160b, 160c may be associated with a particular cell (not shown) and may be configured to handle radio resource management decisions, handover decisions, scheduling of users in the UL and/or DL, and the like. As shown in FIG. 1C, the eNode-Bs 160a, 160b, 160c may communicate with one another over an X2 interface.

The CN 106 shown in FIG. 1C may include a mobility management entity (MME) 162, a serving gateway (SGW) 164, and a packet data network (PDN) gateway (or PGW) 166. While each of the foregoing elements are depicted as part of the CN 106, it will be appreciated that any of these elements may be owned and/or operated by an entity other than the CN operator.

The MME 162 may be connected to each of the eNode-Bs 162a, 162b, 162c in the RAN 104 via an S1 interface and may serve as a control node. For example, the MME 162 may be responsible for authenticating users of the WTRUs 102a, 102b, 102c, bearer activation/deactivation, selecting a particular serving gateway during an initial attach of the WTRUs 102a, 102b, 102c, and the like. The MME 162 may provide a control plane function for switching between the RAN 104 and other RANs (not shown) that employ other radio technologies, such as GSM and/or WCDMA.

The SGW 164 may be connected to each of the eNode Bs 160a, 160b, 160c in the RAN 104 via the S1 interface. The SGW 164 may generally route and forward user data packets to/from the WTRUs 102a, 102b, 102c. The SGW 164 may perform other functions, such as anchoring user planes during inter-eNode B handovers, triggering paging when DL data is available for the WTRUs 102a, 102b, 102c, managing and storing contexts of the WTRUs 102a, 102b, 102c, and the like.

The SGW 164 may be connected to the PGW 166, which may provide the WTRUs 102a, 102b, 102c with access to packet-switched networks, such as the Internet 110, to facilitate communications between the WTRUs 102a, 102b, 102c and IP-enabled devices.

The CN 106 may facilitate communications with other networks. For example, the CN 106 may provide the WTRUs 102a, 102b, 102c with access to circuit-switched networks, such as the PSTN 108, to facilitate communications between the WTRUs 102a, 102b, 102c and traditional land-line communications devices. For example, the CN 106 may include, or may communicate with, an IP gateway (e.g., an IP multimedia subsystem (IMS) server) that serves as an interface between the CN 106 and the PSTN 108. In addition, the CN 106 may provide the WTRUs 102a, 102b, 102c with access to the other networks 112, which may include other wired and/or wireless networks that are owned and/or operated by other service providers.

Although the WTRU is described in FIGS. 1A-1D as a wireless terminal, it is contemplated that in certain representative embodiments that such a terminal may use (e.g., temporarily or permanently) wired communication interfaces with the communication network.

In representative embodiments, the other network 112 may be a WLAN.

A WLAN in Infrastructure Basic Service Set (BSS) mode may have an Access Point (AP) for the BSS and one or more stations (STAs) associated with the AP. The AP may have an access or an interface to a Distribution System (DS) or another type of wired/wireless network that carries traffic in to and/or out of the BSS. Traffic to STAs that originates from outside the BSS may arrive through the AP and may be delivered to the STAs. Traffic originating from STAs to destinations outside the BSS may be sent to the AP to be delivered to respective destinations. Traffic between STAs within the BSS may be sent through the AP, for example, where the source STA may send traffic to the AP and the AP may deliver the traffic to the destination STA. The traffic between STAs within a BSS may be considered and/or referred to as peer-to-peer traffic. The peer-to-peer traffic may be sent between (e.g., directly between) the source and destination STAs with a direct link setup (DLS). In certain representative embodiments, the DLS may use an 802.11e DLS or an 802.11z tunneled DLS (TDLS). A WLAN using an Independent BSS (IBSS) mode may not have an AP, and the STAs (e.g., all of the STAs) within or using the IBSS may communicate directly with each other. The IBSS mode of communication may sometimes be referred to herein as an "ad-hoc" mode of communication.

When using the 802.11ac infrastructure mode of operation or a similar mode of operations, the AP may transmit a beacon on a fixed channel, such as a primary channel. The primary channel may be a fixed width (e.g., 20 MHz wide bandwidth) or a dynamically set width via signaling. The primary channel may be the operating channel of the BSS and may be used by the STAs to establish a connection with the AP. In certain representative embodiments, Carrier Sense Multiple Access with Collision Avoidance (CSMA/CA) may be implemented, for example in in 802.11 systems. For CSMA/CA, the STAs (e.g., every STA), including the AP, may sense the primary channel. If the primary channel is sensed/detected and/or determined to be busy by a particular STA, the particular STA may back off. One STA (e.g., only one station) may transmit at any given time in a given BSS.

High Throughput (HT) STAs may use a 40 MHz wide channel for communication, for example, via a combination of the primary 20 MHz channel with an adjacent or nonadjacent 20 MHz channel to form a 40 MHz wide channel.

Very High Throughput (VHT) STAs may support 20MHz, 40 MHz, 80 MHz, and/or 160 MHz wide channels. The 40 MHz, and/or 80 MHz, channels may be formed by combining contiguous 20 MHz channels. A 160 MHz channel may be formed by combining 8 contiguous 20 MHz channels, or by combining two non-contiguous 80 MHz channels, which may be referred to as an 80+80 configuration. For the 80+80 configuration, the data, after channel encoding, may be passed through a segment parser that may divide the data into two streams. Inverse Fast Fourier Transform (IFFT) processing, and time domain processing, may be done on each stream separately. The streams may be mapped on to the two 80 MHz channels, and the data may be transmitted by a transmitting STA. At the receiver of the receiving STA, the above described operation for the 80+80 configuration may be reversed, and the combined data may be sent to the Medium Access Control (MAC).

Sub 1 GHz modes of operation are supported by 802.11af and 802.11ah. The channel operating bandwidths, and carriers, are reduced in 802.11af and 802.11ah relative to those used in 802.11n, and 802.11ac. 802.11af supports 5 MHz, 10 MHz and 20 MHz bandwidths in the TV White Space (TVWS) spectrum, and 802.11ah supports 1 MHz, 2 MHz, 4 MHz, 8 MHz, and 16 MHz bandwidths using non-TVWS spectrum. According to a representative embodiment, 802.11ah may support Meter Type Control/Machine-Type Communications, such as MTC devices in a macro coverage area. MTC devices may have certain capabilities, for example, limited capabilities including support for (e.g., only support for) certain and/or limited bandwidths. The MTC devices may include a battery with a battery life above a threshold (e.g., to maintain a very long battery life).

WLAN systems, which may support multiple channels, and channel bandwidths, such as 802.11n, 802.11ac, 802.11af, and 802.11ah, include a channel which may be designated as the primary channel. The primary channel may have a bandwidth equal to the largest common operating bandwidth supported by all STAs in the BSS. The bandwidth of the primary channel may be set and/or limited by a STA, from among all STAs in operating in a BSS, which supports the smallest bandwidth operating mode. In the example of 802.11ah, the primary channel may be 1 MHz wide for STAs (e.g., MTC type devices) that support (e.g., only support) a 1 MHz mode, even if the AP, and other STAs in the BSS support 2 MHz, 4 MHz, 8 MHz, 16 MHz, and/or other channel bandwidth operating modes. Carrier sensing and/or Network Allocation Vector (NAV) settings may depend on the status of the primary channel. If the primary channel is busy, for example, due to a STA (which supports only a 1 MHz operating mode), transmitting to the AP, the entire available frequency bands may be considered busy even though a majority of the frequency bands remains idle and may be available.

In the United States, the available frequency bands, which may be used by 802.11ah, are from 902 MHz to 928 MHz. In Korea, the available frequency bands are from 917.5 MHz to 923.5 MHz. In Japan, the available frequency bands are from 916.5 MHz to 927.5 MHz. The total bandwidth available for 802.11ah is 6 MHz to 26 MHz depending on the country code.

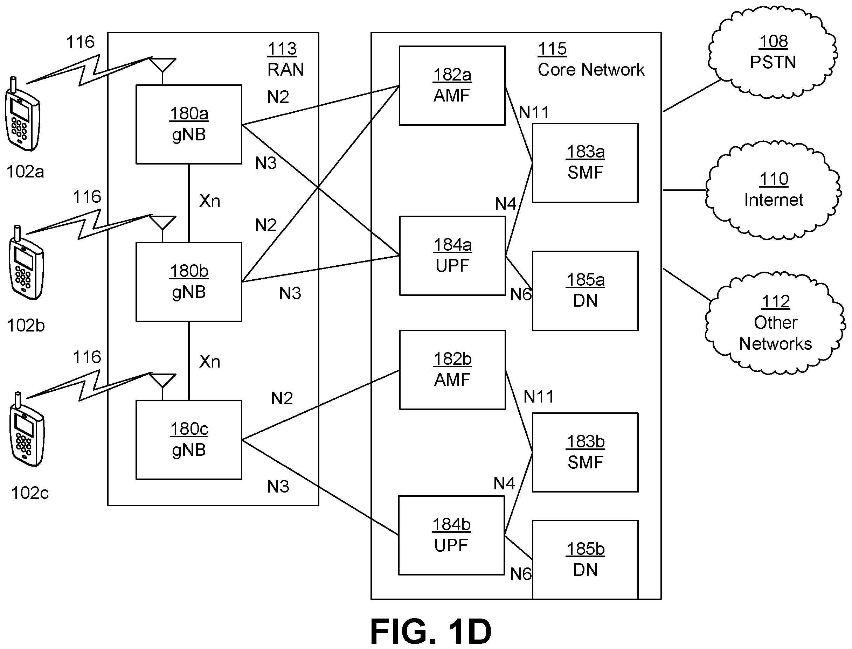

FIG. 1D is a system diagram illustrating the RAN 113 and the CN 115 according to an embodiment. As noted above, the RAN 113 may employ an NR radio technology to communicate with the WTRUs 102a, 102b, 102c over the air interface 116. The RAN 113 may also be in communication with the CN 115.

The RAN 113 may include gNBs 180a, 180b, 180c, though it will be appreciated that the RAN 113 may include any number of gNBs while remaining consistent with an embodiment. The gNBs 180a, 180b, 180c may each include one or more transceivers for communicating with the WTRUs 102a, 102b, 102c over the air interface 116. In one embodiment, the gNBs 180a, 180b, 180c may implement MIMO technology. For example, gNBs 180a, 108b may utilize beamforming to transmit signals to and/or receive signals from the gNBs 180a, 180b, 180c. Thus, the gNB 180a, for example, may use multiple antennas to transmit wireless signals to, and/or receive wireless signals from, the WTRU 102a. In an embodiment, the gNBs 180a, 180b, 180c may implement carrier aggregation technology. For example, the gNB 180a may transmit multiple component carriers to the WTRU 102a (not shown). A subset of these component carriers may be on unlicensed spectrum while the remaining component carriers may be on licensed spectrum. In an embodiment, the gNBs 180a, 180b, 180c may implement Coordinated Multi-Point (CoMP) technology. For example, WTRU 102a may receive coordinated transmissions from gNB 180a and gNB 180b (and/or gNB 180c).

The WTRUs 102a, 102b, 102c may communicate with gNBs 180a, 180b, 180c using transmissions associated with a scalable numerology. For example, the OFDM symbol spacing and/or OFDM subcarrier spacing may vary for different transmissions, different cells, and/or different portions of the wireless transmission spectrum. The WTRUs 102a, 102b, 102c may communicate with gNBs 180a, 180b, 180c using subframe or transmission time intervals (TTIs) of various or scalable lengths (e.g., containing varying number of OFDM symbols and/or lasting varying lengths of absolute time).

The gNBs 180a, 180b, 180c may be configured to communicate with the WTRUs 102a, 102b, 102c in a standalone configuration and/or a non-standalone configuration. In the standalone configuration, WTRUs 102a, 102b, 102c may communicate with gNBs 180a, 180b, 180c without also accessing other RANs (e.g., such as eNode-Bs 160a, 160b, 160c). In the standalone configuration, WTRUs 102a, 102b, 102c may utilize one or more of gNBs 180a, 180b, 180c as a mobility anchor point. In the standalone configuration, WTRUs 102a, 102b, 102c may communicate with gNBs 180a, 180b, 180c using signals in an unlicensed band. In a non-standalone configuration WTRUs 102a, 102b, 102c may communicate with/connect to gNBs 180a, 180b, 180c while also communicating with/connecting to another RAN such as eNode-Bs 160a, 160b, 160c. For example, WTRUs 102a, 102b, 102c may implement DC principles to communicate with one or more gNBs 180a, 180b, 180c and one or more eNode-Bs 160a, 160b, 160c substantially simultaneously. In the non-standalone configuration, eNode-Bs 160a, 160b, 160c may serve as a mobility anchor for WTRUs 102a, 102b, 102c and gNBs 180a, 180b, 180c may provide additional coverage and/or throughput for servicing WTRUs 102a, 102b, 102c.

Each of the gNBs 180a, 180b, 180c may be associated with a particular cell (not shown) and may be configured to handle radio resource management decisions, handover decisions, scheduling of users in the UL and/or DL, support of network slicing, dual connectivity, interworking between NR and E-UTRA, routing of user plane data towards User Plane Function (UPF) 184a, 184b, routing of control plane information towards Access and Mobility Management Function (AMF) 182a, 182b and the like. As shown in FIG. 1D, the gNBs 180a, 180b, 180c may communicate with one another over an Xn interface.

The CN 115 shown in FIG. 1D may include at least one AMF 182a, 182b, at least one UPF 184a, 184b, at least one Session Management Function (SMF) 183a, 183b, and possibly a Data Network (DN) 185a, 185b. While each of the foregoing elements are depicted as part of the CN 115, it will be appreciated that any of these elements may be owned and/or operated by an entity other than the CN operator.

The AMF 182a, 182b may be connected to one or more of the gNBs 180a, 180b, 180c in the RAN 113 via an N2 interface and may serve as a control node. For example, the AMF 182a, 182b may be responsible for authenticating users of the WTRUs 102a, 102b, 102c, support for network slicing (e.g., handling of different PDU sessions with different requirements), selecting a particular SMF 183a, 183b, management of the registration area, termination of NAS signaling, mobility management, and the like. Network slicing may be used by the AMF 182a, 182b in order to customize CN support for WTRUs 102a, 102b, 102c based on the types of services being utilized WTRUs 102a, 102b, 102c. For example, different network slices may be established for different use cases such as services relying on ultra-reliable low latency (URLLC) access, services relying on enhanced massive mobile broadband (eMBB) access, services for machine type communication (MTC) access, and/or the like. The AMF 162 may provide a control plane function for switching between the RAN 113 and other RANs (not shown) that employ other radio technologies, such as LTE, LTE-A, LTE-A Pro, and/or non-3GPP access technologies such as WiFi.

The SMF 183a, 183b may be connected to an AMF 182a, 182b in the CN 115 via an N11 interface. The SMF 183a, 183b may also be connected to a UPF 184a, 184b in the CN 115 via an N4 interface. The SMF 183a, 183b may select and control the UPF 184a, 184b and configure the routing of traffic through the UPF 184a, 184b. The SMF 183a, 183b may perform other functions, such as managing and allocating UE IP address, managing PDU sessions, controlling policy enforcement and QoS, providing downlink data notifications, and the like. A PDU session type may be IP-based, non-IP based, Ethernet-based, and the like.

The UPF 184a, 184b may be connected to one or more of the gNBs 180a, 180b, 180c in the RAN 113 via an N3 interface, which may provide the WTRUs 102a, 102b, 102c with access to packet-switched networks, such as the Internet 110, to facilitate communications between the WTRUs 102a, 102b, 102c and IP-enabled devices. The UPF 184, 184b may perform other functions, such as routing and forwarding packets, enforcing user plane policies, supporting multi-homed PDU sessions, handling user plane QoS, buffering downlink packets, providing mobility anchoring, and the like.

The CN 115 may facilitate communications with other networks. For example, the CN 115 may include, or may communicate with, an IP gateway (e.g., an IP multimedia subsystem (IMS) server) that serves as an interface between the CN 115 and the PSTN 108. In addition, the CN 115 may provide the WTRUs 102a, 102b, 102c with access to the other networks 112, which may include other wired and/or wireless networks that are owned and/or operated by other service providers. In one embodiment, the WTRUs 102a, 102b, 102c may be connected to a local Data Network (DN) 185a, 185b through the UPF 184a, 184b via the N3 interface to the UPF 184a, 184b and an N6 interface between the UPF 184a, 184b and the DN 185a, 185b.

In view of Figures 1A-1D, and the corresponding description of Figures 1A-1D, one or more, or all, of the functions described herein with regard to one or more of: WTRU 102a-d, Base Station 114a-b, eNode-B 160a-c, MME 162, SGW 164, PGW 166, gNB 180a-c, AMF 182a-b, UPF 184a-b, SMF 183a-b, DN 185a-b, and/or any other device(s) described herein, may be performed by one or more emulation devices (not shown). The emulation devices may be one or more devices configured to emulate one or more, or all, of the functions described herein. For example, the emulation devices may be used to test other devices and/or to simulate network and/or WTRU functions.

The emulation devices may be designed to implement one or more tests of other devices in a lab environment and/or in an operator network environment. For example, the one or more emulation devices may perform the one or more, or all, functions while being fully or partially implemented and/or deployed as part of a wired and/or wireless communication network in order to test other devices within the communication network. The one or more emulation devices may perform the one or more, or all, functions while being temporarily implemented/deployed as part of a wired and/or wireless communication network. The emulation device may be directly coupled to another device for purposes of testing and/or may performing testing using over-the-air wireless communications.

The one or more emulation devices may perform the one or more, including all, functions while not being implemented/deployed as part of a wired and/or wireless communication network. For example, the emulation devices may be utilized in a testing scenario in a testing laboratory and/or a non-deployed (e.g., testing) wired and/or wireless communication network in order to implement testing of one or more components. The one or more emulation devices may be test equipment. Direct RF coupling and/or wireless communications via RF circuitry (e.g., which may include one or more antennas) may be used by the emulation devices to transmit and/or receive data.

This application describes a variety of aspects, including tools, features, examples, models, approaches, etc. Many of these aspects are described with specificity and, at least to show the individual characteristics, are often described in a manner that may sound limiting. However, this is for purposes of clarity in description, and does not limit the application or scope of those aspects. Indeed, all of the different aspects may be combined and interchanged to provide further aspects. Moreover, the aspects may be combined and interchanged with aspects described in earlier filings as well.

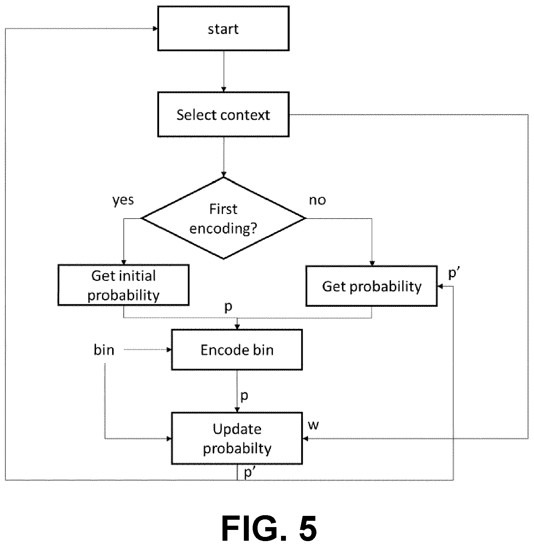

The aspects described and contemplated in this application may be implemented in many different forms. FIGS. 5-10 described herein may provide some examples, but other examples are contemplated. The discussion of FIGS. 5-10 does not limit the breadth of the implementations. At least one of the aspects generally relates to video encoding and decoding, and at least one other aspect generally relates to transmitting a bitstream generated or encoded. These and other aspects may be implemented as a method, an apparatus, a computer readable storage medium having stored thereon instructions for encoding or decoding video data according to any of the methods described, and/or a computer readable storage medium having stored thereon a bitstream generated according to any of the methods described.

In the present application, the terms "reconstructed" and "decoded" may be used interchangeably, the terms "pixel" and "sample" may be used interchangeably, the terms "image," "picture" and "frame" may be used interchangeably.

Various methods are described herein, and each of the methods comprises one or more steps or actions for achieving the described method. Unless a specific order of steps or actions is required for proper operation of the method, the order and/or use of specific steps and/or actions may be modified or combined. Additionally, terms such as "first", "second", etc. may be used in various examples to modify an element, component, step, operation, etc., such as, for example, a "first decoding" and a "second decoding". Use of such terms does not imply an ordering to the modified operations unless specifically required. So, in this example, the first decoding need not be performed before the second decoding, and may occur, for example, before, during, or in an overlapping time period with the second decoding.

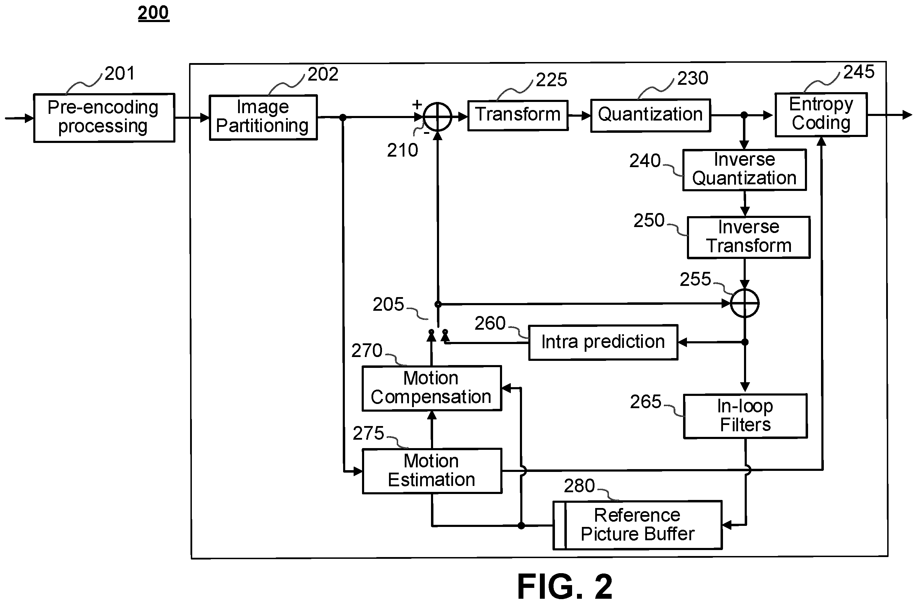

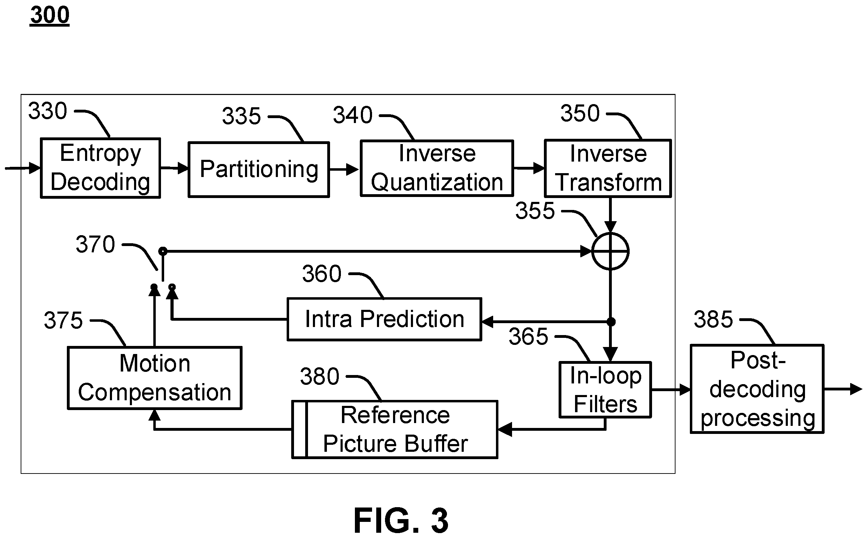

Various methods and other aspects described in this application may be used to modify modules, for example, decoding modules, of a video encoder 200 and decoder 300 as shown in FIG. 2 and FIG. 3. Moreover, the subject matter disclosed herein may be applied, for example, to any type, format or version of video coding, whether described in a standard or a recommendation, whether pre-existing or future-developed, and extensions of any such standards and recommendations. Unless indicated otherwise, or technically precluded, the aspects described in this application may be used individually or in combination.

Various numeric values are used in examples described the present application, such as the number of bits used to encode data (e.g., window size), etc. These and other specific values are for purposes of describing examples and the aspects described are not limited to these specific values.

FIG. 2 is a diagram showing an example video encoder. Variations of example encoder 200 are contemplated, but the encoder 200 is described below for purposes of clarity without describing all expected variations.

Before being encoded, the video sequence may go through pre-encoding processing (201), for example, applying a color transform to the input color picture (e.g., conversion from RGB 4:4:4 to YCbCr 4:2:0), or performing a remapping of the input picture components in order to get a signal distribution more resilient to compression (for instance using a histogram equalization of one of the color components). Metadata may be associated with the pre-processing, and attached to the bitstream.

In the encoder 200, a picture is encoded by the encoder elements as described below. The picture to be encoded is partitioned (202) and processed in units of, for example, coding units (CUs). Each unit is encoded using, for example, either an intra or inter mode. When a unit is encoded in an intra mode, it performs intra prediction (260). In an inter mode, motion estimation (275) and compensation (270) are performed. The encoder decides (205) which one of the intra mode or inter mode to use for encoding the unit, and indicates the intra/inter decision by, for example, a prediction mode flag. Prediction residuals are calculated, for example, by subtracting (210) the predicted block from the original image block.

The prediction residuals are then transformed (225) and quantized (230). The quantized transform coefficients, as well as motion vectors and other syntax elements, are entropy coded (245) to output a bitstream. The encoder can skip the transform and apply quantization directly to the non-transformed residual signal. The encoder can bypass both transform and quantization, i.e., the residual is coded directly without the application of the transform or quantization processes.

The encoder decodes an encoded block to provide a reference for further predictions. The quantized transform coefficients are de-quantized (240) and inverse transformed (250) to decode prediction residuals. Combining (255) the decoded prediction residuals and the predicted block, an image block is reconstructed. In-loop filters (265) are applied to the reconstructed picture to perform, for example, deblocking/SAO (Sample Adaptive Offset) filtering to reduce encoding artifacts. The filtered image is stored at a reference picture buffer (280).

FIG. 3 is a diagram showing an example of a video decoder. In example decoder 300, a bitstream is decoded by the decoder elements as described below. Video decoder 300 generally performs a decoding pass reciprocal to the encoding pass as described in FIG. 2. The encoder 200 also generally performs video decoding as part of encoding video data.

In particular, the input of the decoder includes a video bitstream, which may be generated by video encoder 200. The bitstream is first entropy decoded (330) to obtain transform coefficients, motion vectors, and other coded information. The picture partition information indicates how the picture is partitioned. The decoder may therefore divide (335) the picture according to the decoded picture partitioning information. The transform coefficients are de-quantized (340) and inverse transformed (350) to decode the prediction residuals. Combining (355) the decoded prediction residuals and the predicted block, an image block is reconstructed. The predicted block may be obtained (370) from intra prediction (360) or motion-compensated prediction (i.e., inter prediction) (375). In-loop filters (365) are applied to the reconstructed image. The filtered image is stored at a reference picture buffer (380).

The decoded picture can further go through post-decoding processing (385), for example, an inverse color transform (e.g. conversion from YCbCr 4:2:0 to RGB 4:4:4) or an inverse remapping performing the inverse of the remapping process performed in the pre-encoding processing (201). The post-decoding processing can use metadata derived in the pre-encoding processing and signaled in the bitstream. In an example, the decoded images (e.g., after application of the in-loop filters (365) and/or after post-decoding processing (385), if post-decoding processing is used) may be sent to a display device for rendering to a user.

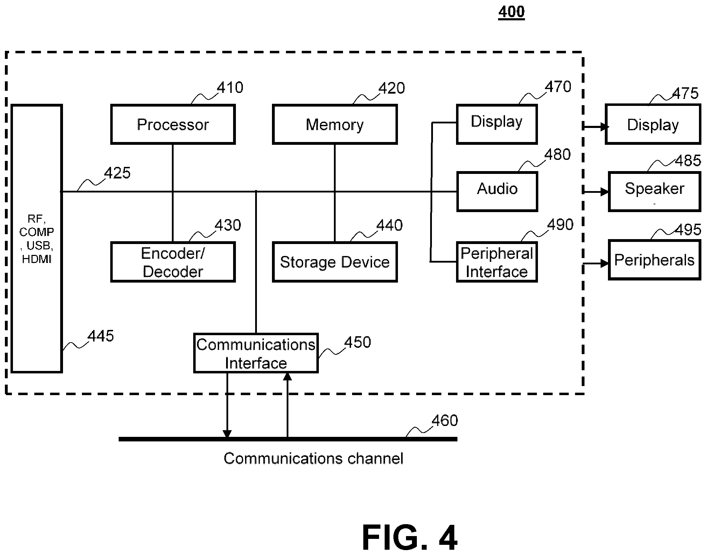

FIG. 4 is a diagram showing an example of a system in which various aspects and examples described herein may be implemented. System 400 may be embodied as a device including the various components described below and is configured to perform one or more of the aspects described in this document. Examples of such devices, include, but are not limited to, various electronic devices such as personal computers, laptop computers, smartphones, tablet computers, digital multimedia set top boxes, digital television receivers, personal video recording systems, connected home appliances, and servers. Elements of system 400, singly or in combination, may be embodied in a single integrated circuit (IC), multiple ICs, and/or discrete components. For example, in at least one example, the processing and encoder/decoder elements of system 400 are distributed across multiple ICs and/or discrete components. In various examples, the system 400 is communicatively coupled to one or more other systems, or other electronic devices, via, for example, a communications bus or through dedicated input and/or output ports. In various examples, the system 400 is configured to implement one or more of the aspects described in this document.

The system 400 includes at least one processor 410 configured to execute instructions loaded therein for implementing, for example, the various aspects described in this document. Processor 410 can include embedded memory, input output interface, and various other circuitries as known in the art. The system 400 includes at least one memory 420 (e.g., a volatile memory device, and/or a non-volatile memory device). System 400 includes a storage device 440, which can include non-volatile memory and/or volatile memory, including, but not limited to, Electrically Erasable Programmable Read-Only Memory (EEPROM), Read-Only Memory (ROM), Programmable Read-Only Memory (PROM), Random Access Memory (RAM), Dynamic Random Access Memory (DRAM), Static Random Access Memory (SRAM), flash, magnetic disk drive, and/or optical disk drive. The storage device 440 can include an internal storage device, an attached storage device (including detachable and non-detachable storage devices), and/or a network accessible storage device, as non-limiting examples.

System 400 includes an encoder/decoder module 430 configured, for example, to process data to provide an encoded video or decoded video, and the encoder/decoder module 430 can include its own processor and memory. The encoder/decoder module 430 represents module(s) that may be included in a device to perform the encoding and/or decoding functions. As is known, a device can include one or both of the encoding and decoding modules. Additionally, encoder/decoder module 430 may be implemented as a separate element of system 400 or may be incorporated within processor 410 as a combination of hardware and software as known to those skilled in the art.

Program code to be loaded onto processor 410 or encoder/decoder 430 to perform the various aspects described in this document may be stored in storage device 440 and subsequently loaded onto memory 420 for execution by processor 410. In accordance with various examples, one or more of processor 410, memory 420, storage device 440, and encoder/decoder module 430 can store one or more of various items during the performance of the processes described in this document. Such stored items can include, but are not limited to, the input video, the decoded video or portions of the decoded video, the bitstream, matrices, variables, and intermediate or final results from the processing of equations, formulas, operations, and operational logic.

In some examples, memory inside of the processor 410 and/or the encoder/decoder module 430 is used to store instructions and to provide working memory for processing that is needed during encoding or decoding. In other examples, however, a memory external to the processing device (for example, the processing device may be either the processor 410 or the encoder/decoder module 430) is used for one or more of these functions. The external memory may be the memory 420 and/or the storage device 440, for example, a dynamic volatile memory and/or a non-volatile flash memory. In several examples, an external non-volatile flash memory is used to store the operating system of, for example, a television. In at least one example, a fast external dynamic volatile memory such as a RAM is used as working memory for video encoding and decoding operations.

The input to the elements of system 400 may be provided through various input devices as indicated in block 445.

Such input devices include, but are not limited to, (i) a radio frequency (RF) portion that receives an RF signal transmitted, for example, over the air by a broadcaster, (ii) a Component (COMP) input terminal (or a set of COMP input terminals), (iii) a Universal Serial Bus (USB) input terminal, and/or (iv) a High Definition Multimedia Interface (HDMI) input terminal. Other examples, not shown in FIG. 4, include composite video.

In various examples, the input devices of block 445 have associated respective input processing elements as known in the art. For example, the RF portion may be associated with elements suitable for (i) selecting a desired frequency (also referred to as selecting a signal, or band-limiting a signal to a band of frequencies), (ii) downconverting the selected signal, (iii) band-limiting again to a narrower band of frequencies to select (for example) a signal frequency band which may be referred to as a channel in certain examples, (iv) demodulating the downconverted and band-limited signal, (v) performing error correction, and/or (vi) demultiplexing to select the desired stream of data packets. The RF portion of various examples includes one or more elements to perform these functions, for example, frequency selectors, signal selectors, band-limiters, channel selectors, filters, downconverters, demodulators, error correctors, and demultiplexers. The RF portion can include a tuner that performs various of these functions, including, for example, downconverting the received signal to a lower frequency (for example, an intermediate frequency or a near-baseband frequency) or to baseband. In one set-top box example, the RF portion and its associated input processing element receives an RF signal transmitted over a wired (for example, cable) medium, and performs frequency selection by filtering, downconverting, and filtering again to a desired frequency band. Various examples rearrange the order of the above-described (and other) elements, remove some of these elements, and/or add other elements performing similar or different functions. Adding elements can include inserting elements in between existing elements, such as, for example, inserting amplifiers and an analog-to-digital converter. In various examples, the RF portion includes an antenna.

The USB and/or HDMI terminals can include respective interface processors for connecting system 400 to other electronic devices across USB and/or HDMI connections. It is to be understood that various aspects of input processing, for example, Reed-Solomon error correction, may be implemented, for example, within a separate input processing IC or within processor 410 as necessary. Similarly, aspects of USB or HDMI interface processing may be implemented within separate interface ICs or within processor 410 as necessary. The demodulated, error corrected, and demultiplexed stream is provided to various processing elements, including, for example, processor 410, and encoder/decoder 430 operating in combination with the memory and storage elements to process the datastream as necessary for presentation on an output device.

Various elements of system 400 may be provided within an integrated housing, Within the integrated housing, the various elements may be interconnected and transmit data therebetween using suitable connection arrangement 425, for example, an internal bus as known in the art, including the Inter-IC (I2C) bus, wiring, and printed circuit boards.

The system 400 includes communication interface 450 that enables communication with other devices via communication channel 460. The communication interface 450 can include, but is not limited to, a transceiver configured to transmit and to receive data over communication channel 460. The communication interface 450 can include, but is not limited to, a modem or network card and the communication channel 460 may be implemented, for example, within a wired and/or a wireless medium.

Data is streamed, or otherwise provided, to the system 400, in various examples, using a wireless network such as a Wi-Fi network, for example IEEE 802.11 (IEEE refers to the Institute of Electrical and Electronics Engineers). The Wi-Fi signal of these examples is received over the communications channel 460 and the communications interface 450 which are adapted for Wi-Fi communications. The communications channel 460 of these examples is typically connected to an access point or router that provides access to external networks including the Internet for allowing streaming applications and other over-the-top communications. Other examples provide streamed data to the system 400 using a set-top box that delivers the data over the HDMI connection of the input block 445. Still other examples provide streamed data to the system 400 using the RF connection of the input block 445. As indicated above, various examples provide data in a non-streaming manner. Additionally, various examples use wireless networks other than Wi-Fi, for example a cellular network or a Bluetooth® network.

The system 400 can provide an output signal to various output devices, including a display 475, speakers 485, and other peripheral devices 495. The display 475 of various examples includes one or more of, for example, a touchscreen display, an organic light-emitting diode (OLED) display, a curved display, and/or a foldable display. The display 475 may be for a television, a tablet, a laptop, a cell phone (mobile phone), or other device. The display 475 can also be integrated with other components (for example, as in a smart phone), or separate (for example, an external monitor for a laptop). The other peripheral devices 495 include, in various examples, one or more of a stand-alone digital video disc (or digital versatile disc) (DVD, for both terms), a disk player, a stereo system, and/or a lighting system. Various examples use one or more peripheral devices 495 that provide a function based on the output of the system 400. For example, a disk player performs the function of playing the output of the system 400.

In various examples, control signals are communicated between the system 400 and the display 475, speakers 485, or other peripheral devices 495 using signaling such as AV.Link, Consumer Electronics Control (CEC), or other communications protocols that enable device-to-device control with or without user intervention. The output devices may be communicatively coupled to system 400 via dedicated connections through respective interfaces 470, 480, and 490. Alternatively, the output devices may be connected to system 400 using the communications channel 460 via the communications interface 450. The display 475 and speakers 485 may be integrated in a single unit with the other components of system 400 in an electronic device such as, for example, a television. In various examples, the display interface 470 includes a display driver, such as, for example, a timing controller (T Con) chip.

The display 475 and speakers 485 can alternatively be separate from one or more of the other components, for example, if the RF portion of input 445 is part of a separate set-top box. In various examples in which the display 475 and speakers 485 are external components, the output signal may be provided via dedicated output connections, including, for example, HDMI ports, USB ports, or COMP outputs.

The examples may be carried out by computer software implemented by the processor 410 or by hardware, or by a combination of hardware and software. As a non-limiting example, the examples may be implemented by one or more integrated circuits. The memory 420 may be of any type appropriate to the technical environment and may be implemented using any appropriate data storage technology, such as optical memory devices, magnetic memory devices, semiconductor-based memory devices, fixed memory, and removable memory, as non-limiting examples. The processor 410 may be of any type appropriate to the technical environment, and can encompass one or more of microprocessors, general purpose computers, special purpose computers, and processors based on a multi-core architecture, as non-limiting examples.

Various implementations involve decoding. "Decoding", as used in this application, can encompass all or part of the processes performed, for example, on a received encoded sequence in order to produce a final output suitable for display. In various examples, such processes include one or more of the processes typically performed by a decoder, for example, entropy decoding, inverse quantization, inverse transformation, and differential decoding. In various examples, such processes also, or alternatively, include processes performed by a decoder of various implementations described in this application, for example, processing a video bin according to an associated context, etc.

As further examples, in one example "decoding" refers only to entropy decoding, in another example "decoding" refers only to differential decoding, and in another example "decoding" refers to a combination of entropy decoding and differential decoding. Whether the phrase "decoding process" is intended to refer specifically to a subset of operations or generally to the broader decoding process will be clear based on the context of the specific descriptions and is believed to be well understood by those skilled in the art.

Various implementations involve encoding. In an analogous way to the above discussion about "decoding", "encoding" as used in this application can encompass all or part of the processes performed, for example, on an input video sequence in order to produce an encoded bitstream. In various examples, such processes include one or more of the processes typically performed by an encoder, for example, partitioning, differential encoding, transformation, quantization, and entropy encoding. In various examples, such processes also, or alternatively, include processes performed by an encoder of various implementations described in this application, for example, processing a video bin according to an associated context, etc.

As further examples, in one example "encoding" refers only to entropy encoding, in another example "encoding" refers only to differential encoding, and in another example "encoding" refers to a combination of differential encoding and entropy encoding. Whether the phrase "encoding process" is intended to refer specifically to a subset of operations or generally to the broader encoding process will be clear based on the context of the specific descriptions and is believed to be well understood by those skilled in the art.

Note that syntax elements as used herein, for example, coding syntax on index, functions, indications etc., are descriptive terms. As such, they do not preclude the use of other syntax element names.

When a figure is presented as a flow diagram, it should be understood that it also provides a block diagram of a corresponding apparatus. Similarly, when a figure is presented as a block diagram, it should be understood that it also provides a flow diagram of a corresponding method/process.

The implementations and aspects described herein may be implemented in, for example, a method or a process, an apparatus, a software program, a data stream, or a signal. Even if only discussed in the context of a single form of implementation (for example, discussed only as a method), the implementation of features discussed can also be implemented in other forms (for example, an apparatus or program). An apparatus may be implemented in, for example, appropriate hardware, software, and firmware. The methods may be implemented in, for example, a processor, which refers to processing devices in general, including, for example, a computer, a microprocessor, an integrated circuit, or a programmable logic device. Processors also include communication devices, such as, for example, computers, cell phones, portable/personal digital assistants ("PDAs"), and other devices that facilitate communication of information between end-users.

Reference to "one example" or "an example" or "one implementation" or "an implementation", as well as other variations thereof, means that a particular feature, structure, characteristic, and so forth described in connection with the example is included in at least one example. Thus, the appearances of the phrase "in one example" or "in an example" or "in one implementation" or "in an implementation", as well any other variations, appearing in various places throughout this application are not necessarily all referring to the same example.

Additionally, this application may refer to "determining" various pieces of information. Determining the information can include one or more of, for example, estimating the information, calculating the information, predicting the information, or retrieving the information from memory. Obtaining may include receiving, retrieving, constructing, generating, and/or determining.

Further, this application may refer to "accessing" various pieces of information. Accessing the information can include one or more of, for example, receiving the information, retrieving the information (for example, from memory), storing the information, moving the information, copying the information, calculating the information, determining the information, predicting the information, or estimating the information.

Additionally, this application may refer to "receiving" various pieces of information. Receiving is, as with "accessing", intended to be a broad term. Receiving the information can include one or more of, for example, accessing the information, or retrieving the information (for example, from memory). Further, "receiving" is typically involved, in one way or another, during operations such as, for example, storing the information, processing the information, transmitting the information, moving the information, copying the information, erasing the information, calculating the information, determining the information, predicting the information, or estimating the information.

It is to be appreciated that the use of any of the following "/", "and/or", and "at least one of", for example, in the cases of "A/B", "A and/or B" and "at least one of A and B", is intended to encompass the selection of the first listed option (A) only, or the selection of the second listed option (B) only, or the selection of both options (A and B). As a further example, in the cases of "A, B, and/or C" and "at least one of A, B, and C", such phrasing is intended to encompass the selection of the first listed option (A) only, or the selection of the second listed option (B) only, or the selection of the third listed option (C) only, or the selection of the first and the second listed options (A and B) only, or the selection of the first and third listed options (A and C) only, or the selection of the second and third listed options (B and C) only, or the selection of all three options (A and B and C). This may be extended, as is clear to one of ordinary skill in this and related arts, for as many items as are listed.

Also, as used herein, the word "signal" refers to, among other things, indicating something to a corresponding decoder. Encoder signals may include, for example, bits_coding_profile, etc. In this way, in an example the same parameter is used at both the encoder side and the decoder side. Thus, for example, an encoder can transmit (explicit signaling) a particular parameter to the decoder so that the decoder can use the same particular parameter. Conversely, if the decoder already has the particular parameter as well as others, then signaling may be used without transmitting (implicit signaling) to simply allow the decoder to know and select the particular parameter. By avoiding transmission of any actual functions, a bit savings is realized in various examples. It is to be appreciated that signaling may be accomplished in a variety of ways. For example, one or more syntax elements, flags, and so forth are used to signal information to a corresponding decoder in various examples. While the preceding relates to the verb form of the word "signal", the word "signal" can also be used herein as a noun.

As will be evident to one of ordinary skill in the art, implementations may produce a variety of signals formatted to carry information that may be, for example, stored or transmitted. The information can include, for example, instructions for performing a method, or data produced by one of the described implementations. For example, a signal may be formatted to carry the bitstream of a described example. Such a signal may be formatted, for example, as an electromagnetic wave (for example, using a radio frequency portion of spectrum) or as a baseband signal. The formatting may include, for example, encoding a data stream and modulating a carrier with the encoded data stream. The information that the signal carries may be, for example, analog or digital information. The signal may be transmitted over a variety of different wired or wireless links, as is known. The signal may be stored on, or accessed or received from, a processor-readable medium.

Many examples are described herein. Features of examples may be provided alone or in any combination, across various claim categories and types. Further, examples may include one or more of the features, devices, or aspects described herein, alone or in any combination, across various claim categories and types. For example, features described herein may be implemented in a bitstream or signal that includes information generated as described herein. The information may allow a decoder to decode a bitstream, the encoder, bitstream, and/or decoder according to any of the embodiments described. For example, features described herein may be implemented by creating and/or transmitting and/or receiving and/or decoding a bitstream or signal. For example, features described herein may be implemented a method, process, apparatus, medium storing instructions, medium storing data, or signal. For example, features described herein may be implemented by a TV, set-top box, cell phone, tablet, or other electronic device that performs decoding. The TV, set-top box, cell phone, tablet, or other electronic device may display (e.g. using a monitor, screen, or other type of display) a resulting image (e.g., an image from residual reconstruction of the video bitstream). The TV, set-top box, cell phone, tablet, or other electronic device may receive a signal including an encoded image and perform decoding.

Video coding may use an entropy coder and/or entropy decoder in a video codec. A Context Adaptive Binary Arithmetic Coder (CABAC) may use a dynamic model switch and/or parameterization.

A video codec may perform a large part of signaling, for example, using entropy coding of the values to transmit. CABAC may encode (e.g., only) binary values. Generic values may (e.g., first) undergo a binarization process, e.g., prior to CABAC encoding. A context may (e.g., also) be attached for a (e.g., each individual) bin to encode, for example, so that the probability of the (e.g., each) bin to encode may be updated after an (e.g., each) encoding/decoding. For example, the probability may be updated based on (e.g., according to) the value taken by the considered coded bin. The speed at which the probability is updated may be a parameter of the model (e.g., the probability model associated to the bin).

The speed at which the probability is updated and/or the initial probability used may be parameters of the model.

For each individual binary symbol (bin) to encode, a probability model may be attached, for example to represent the conditional probability of the bin being equal to 1 or 0. The probability model may depend on contextual information. The probability model may enable an average coding rate for the considered bin that is close to the theoretical lower bound defined by the conditional entropy of the binary symbol given the contextual information. This conditional entropy may be lower (e.g., is lower) than the non-contextual entropy, leading to a lower coding rate.

In the following, the probability of a bin may refer to the probability that the bin is equal to 1.

An example of entropy coding by a video codec is shown in FIG. 5. For example, a context may be selected, for example, for each bin. A (e.g., each) context may include, for example, one or more of the following information: current probability; windows size(s); a weighted sum of probabilities; parameters dw00, dw01, dw10, dw11, and/or an initial probability. A current probability may include one or more probabilities. For example, a codec may maintain two (2) probabilities, e.g., p0 and p1.

One or more window sizes may correspond, for example, to the update speed of a probability. A probability may be updated, for example, in accordance with Eq. (1):

$$p_{next} = \alpha * b + (1 - \alpha) * p \qquad\qquad (1)$$

where p may be the previous probability, $p_{next}$ may be the updated probability, b may be the current bin encoded/decoded, and $\alpha=1/2*w$, where w may be the window size (e.g., which may determine the speed at which the probability is updated). For example, a codec may update two (2) probabilities using two (2) different window sizes, e.g., w0 and w1. A (e.g., each) bin may (e.g., then) be encoded/decoded, for example, by considering the weighted sum of the (e.g., two) probabilities (e.g., p0 and p1) using the weight a. Window size(s) may be updated, for example, each time a bin has been read, which may depend on one or more parameters, e.g., dw00, dw01, dw10, and/or dw11.

An initial probability may be created/maintained. One or more parameters (e.g., p0 and/or p1) may be initialized, for example, using an initial probability (e.g., the same initial probability).

The parameters for a given context (e.g., initial probability, windows sizes, weight between probabilities) may depend on one or more of the following (e.g., external) parameters: the type of slice to encode (e.g., intra (I), biprediction (B), or uni-direction (P)); and/or a quantization parameter qp.

A (e.g., each) context may use fixed (e.g., between encoder and decoder) parameters. The parameters may be decided, for example, per context.

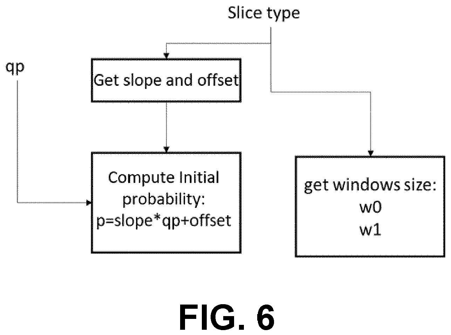

Parameters may be initialized, for example, at the beginning of a (e.g., each) slice, as depicted by example in FIG. 6. A flag (e.g., sh_cabac_init_flag) may be signaled in the slice header for a non intra slice. The indication provided by the flag may allow switching of the parameters that may be used for initialization, e.g., depending on the type of slice to encode. For example, if/when the flag is true for a B slice, a P slice parameter set may be used, and the other way around. Table 1 shows an example of syntax using the CABAC initialization flag.

Table 1 - Example of syntax using the CABAC initialization flag

| | |
|---|---|
| if( sh_slice_type != I ) { | |
| if( pps_cabac_init_present_flag ) | |
| **sh_cabac_init_flag** | u(1) |

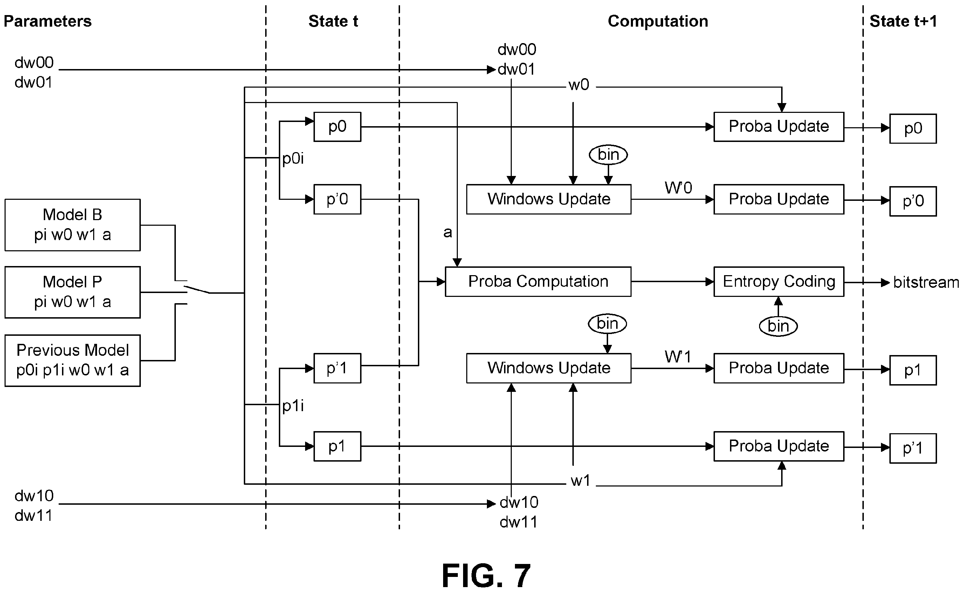

FIG. 7 illustrates an example of a CABAC engine. As shown in FIG. 7, the values of the parameters shown in FIG. 7 (e.g., parameter values) may be selected/fixed for a particular context. The example shows three contexts/parameter sets. For a B or P slice, a selection may be made between three (3) parameter sets: B, P, or previous model. In some examples (e.g., as shown in FIG. 7), the dw values may be shared for multiple (e.g., all) models (e.g., B, P, I, and/or previous model).

A bin may be encoded/decoded, for example, based on the value of p, which may depend on probabilities p'0 and p'1, for example, in accordance with Eq. (2):

$$p=a*p'0+(1-a)*p'1 \qquad\qquad (2)$$

The probabilities p0 and p1 may (e.g., then) be updated, for example, depending on the bin value, which may be determined in accordance with Eqs. (3):

$$p0\_next= alpha0 * b + (1-alpha0) *p0, \text{ where } alpha0=1/2^{\wedge}w0 \tag{3}$$

$$p1\_next= alpha1 * b + (1-alpha1) *p1, \text{ where } alpha1=1/2^{\wedge}w1$$

The windows size may be updated from w0 and w1 using the bin value and the dw parameters, for example, in accordance with Eqs. (4):

$$w'0=w0+dw0[b] \tag{4}$$

$$w'1=w1+dw1[b]$$

The probability p'0 and p'1 may (e.g., then) be updated depending on the bin value, for example, in accordance with Eqs. (5):

$$p0'\_next= alpha0' * b + (1-alpha0') *p0, \text{ where } alpha0'=1/2^{\wedge}w0' \tag{5}$$

$$p1'\_next= alpha1' * b + (1-alpha1') *p1, \text{ where } alpha1'=1/2^{\wedge}w1'$$

Entropy coding may use a CABAC, which may include, for example, one or more of the following: a core CABAC engine; a separate residual coding structure for a transform block and a transform skip block; and/or context modeling for transform coefficients.

A CABAC engine may use a table-based probability transition process between (e.g., 64) different representative probability states. A range (e.g., denoted ivlCurrRange) may represent the state of the coding engine. The range may be quantized to a set of (e.g., four (4)) values prior to the calculation of the new interval range. A state transition may be implemented, for example, using a table containing (e.g., 64x4 8-bit pre-computed) values to approximate the values of ivlCurrRange * pLPS( pStateIdx ), where pLPS may be the probability of the least probable symbol (LPS) and pStateIdx may be the index of the current state. A decode decision may be implemented, for example, using a pre-computed look up table (LUT). A value of ivlLpsRange may (e.g., first) be obtained, for example, using the LUT. The value of ivlLpsRange may be determined, for example, in accordance with Eq. (6). The determined/looked-up value of ivlLpsRange may be used to update ivlCurrRange and/or to calculate the output binVal.

$$ivlLpsRange = rangeTabLps[ pStateIdx ][ qRangeIdx ] \tag{6}$$

A probability may be linearly expressed, for example, by the probability index pStateIdx. Calculations may be performed with equations, e.g., without LUT operation. A multi-hypothesis probability update model may be applied, for example, to improve the accuracy of probability estimation. The pStateIdx used in the interval subdivision in the binary arithmetic coder may be a combination of (e.g., two) probabilities (e.g., pStateIdx0 and pStateIdx1). The (e.g., two) probabilities may be associated with each context model. The probabilities may be updated independently, for example, with different adaptation rates. The adaptation rates of pStateIdx0 and pStateIdx1 for each context model may be pre-trained, for example, based on the statistics of the associated bins. The probability estimate pStateIdx may be the weighted average of the estimates from the (e.g., two) hypotheses.

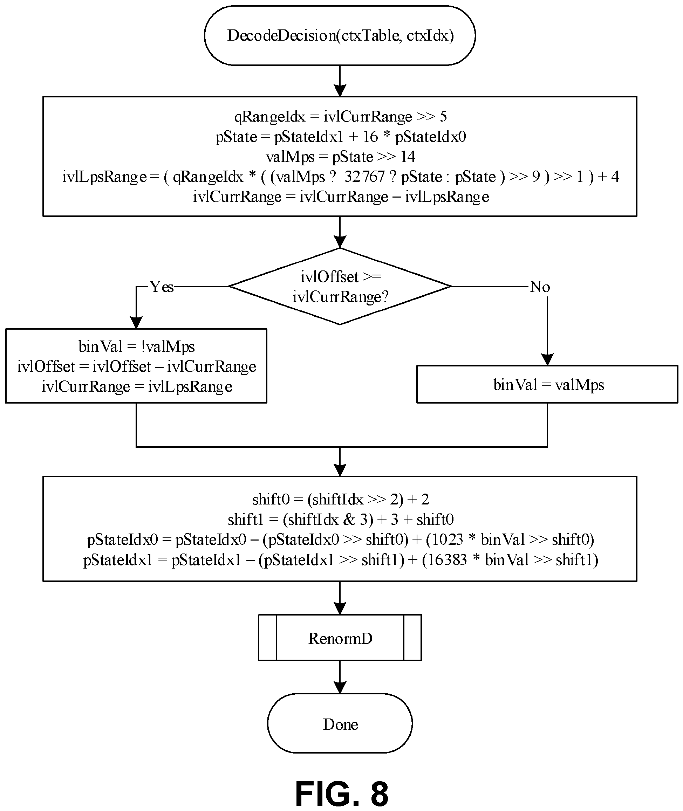

FIG. 8 illustrates a flowchart showing an example for decoding a (e.g., single) binary decision. A CABAC may (e.g., also) have a QP dependent initialization process, which may be invoked at the beginning of a (e.g., each) slice. An initial value of luma QP for the slice may be given/selected/determined. The initial probability state of a context model, denoted as preCtxState, may be derived, for example, in accordance with Eq. (7) - Eq. (11) as follows:

$$m = slopeIdx \times 5 - 45 \tag{7}$$

$$n = (offsetIdx << 3) +7 \tag{8}$$

$$preCtxState = Clip3(1, 127, ((m \times (QP - 32)) >> 4) + n) \tag{9}$$

where slopeIdx and offsetIdx may be restricted to a number of bits (e.g., 3 bits). Total initialization values may be represented by a (pre)determined precision (e.g., 6-bit precision). The probability state preCtxState may represent the probability in the linear domain, e.g., directly. Probability state preCtxState may need (e.g., only) proper shifting operations before being input into an arithmetic coding engine. The logarithmic to linear domain mapping and/or the table (e.g., 256-byte table) may be saved.

$$pStateIdx0 = preCtxState << 3 \tag{10}$$

$$pStateIdx1 = preCtxState << 7 \tag{11}$$

Entropy coding may be implemented with selected precision. Intermediate precision that may be used in an arithmetic coding engine may be increased, for example, including multiple (e.g., three) elements. The precision for (e.g., two) probability states may be, for example, 15 bits, e.g., in comparison to 10 bits and 14 bits in some examples. The LPS range update process may be determined, for example, in accordance with Eq. (12) and accompanying logic:

$$
\begin{aligned}
&\text{if } q >= 16384 \\
&\qquad q = 2^{15} - 1 - q \\
&R_{LPS} = ((range * (q>>6)) >>9) + 1 \tag{12}
\end{aligned}
$$

where range may be a (e.g., 9-bit) variable representing the width of the current interval, q may be a (e.g., 15-bit) variable representing the probability state of the current context model, and $R_{LPS}$ may be the updated range for LPS. The operation may (e.g., also) be realized, for example, by looking up an entry (e.g., a $512 \times 256$-entry) in a (e.g., 9-bit) look-up table. At the encoder side, the look-up table used for bits estimation may be implemented, for example, with 256 or 512 entries.
Window size may be based on slice type. Statistics may be different with different slice types. A context probability state may be updated at a rate that may be optimal under the given slice type. For example, three window sizes may be predefined for I-slices, B-slices, and P-slices, respectively, as the initialization parameters for a (e.g., each) context model. The context initialization parameters and/or window sizes may be retrained.
In some examples, update rates may be adaptive (e.g., adaptive update rates). In some examples, the probability state used for coding may be a weighted average. In some examples, a state may be carried-over/inherited.
Update rules may be implemented for the (e.g., two) probability states, e.g., pStateIdx0 and pStateIdx1. Encoding of the n-th bit of a context may be performed using probability states pStateIdx0' and pStateIdx1', which may be obtained from pStateIdx0 and pStateIdx1 using window sizes that may depend on the (n-1)-th bin, for example, in accordance with Eq. (13) and Eq. (14):

$$w0'(n) = w0 + d0(b_{n-1})$$

$$w1'(n) = w1 + d1(b_{n-1})$$

$$pStateIdx0'(n) = (1-1/2^{w0'(n)})*pStateIdx0(n-1) + 1/2^{w0'(n)}*b_{n-1} \tag{13}$$

$$pStateIdx1'(n) = (1-1/2^{w1'(n)})*pStateIdx1(n-1) + 1/2^{w1'(n)}*b_{n-1} \tag{14}$$

and d0(b), d1(b) are lookup tables on offset values d00,d01,d10,d11 defined at init for the context, added to the window size w0,w1.
The probability state used for coding may be a weighted average of pStateIdx0' and pStateIdx1' (e.g., instead of a simple average), for example, in accordance with Eq. (15):

$$pStateIdx(n) = a*pStateIdx0'(n) + (1-a)*pStateIdx1'(n) \tag{15}$$

where the parameter alpha (e.g., a in FIG. 7) may be obtained, for example, from an LUT. The parameter alpha (a) may depend on the context and/or on the slice type.

The initial state of one or more (e.g., some) B or P-slices may be inherited from previous slices, for example, instead of being re-initialized at each slice. For example, the two final states of each B-slice (or P-slice) may be stored and used to initialize the next B-slice (or P-slice) in the same intra-period sharing the same temporal level and qp.

For a slice (e.g., each slice), context adaptive binary arithmetic coding (CABAC) may encode/decode a series of bins $b_i$, in specific contexts with distinct probability model(s). A number of syntax elements may use equi-probable (EP) encoding/decoding (e.g., the bin may be encoded and decoded by emitting the bin value (0 or 1)).

Among the syntax elements, some elements may or may not use the optimal distribution modeling (e.g., adaptive probability model or equi-probable). Fixed code, such as Huffman code, may be used to take into account fixed probability.

One or more of the following may be implemented, for example to adapt NABAC and multi-models.

Syntax elements may be encoded using one or more of CABAC, NABAC, or EP (e.g., all 3 models).

EP syntax elements may be adapted to be compatible with a CABAC and/or NABAC encoding/decoding (e.g., binarization adaptation, of sign encoding, exponential golomb).

The choice of the model may be encoded such that it does not increase the required memory to store the model.

The syntax elements may use the same encoding process. The syntax elements may use a context, for example even when the mode is EP in order to handle syntax elements with mixed EP/non EP mode depending on the slice type. Syntax elements using the same encoding process may allow for later optimization of which elements choose the CABAC, NABAC, and/or EP.

Depending on some profiles/constraints, the amount of CABAC/NABAC/EP may be chosen optimally. A signaling may be described to choose the amount of each coding mode.

Feature(s) associated with unified multi models are provided herien. Available models may include one or more of CABAC, NABAC, or EP. CABAC may be an encoding/decoding model which can adapt to both the context (e.g., already decoded information) and the distribution of the bins. NABAC may be an encoding/decoding model which can adapt to a context, but the distribution may be considered as a fixed probability (e.g., it may be a sub-case of CABAC where the probabilities are not updated during encoding/decoding but computed offline). EP may be a particular case of NABAC where the probability is set to 0.5. EP may imply some simplification during the encoding/decoding of bins process.

A context may be computed using a set of states (available at both encoder and decoder) during the encoding/decoding process. Example elements used to compute the current context of a bin may include one or more of a slice type; a mode of the blocks on top and/or left of the current mode; or the values of some other mode in the block.

The slice type may be used to compute the current context of a bin and may refer to the type of the current slice. For example, the current slice may be intra.

The mode of the blocks on top and/or left of the current mode may be used to compute the current context of a bin. For example, the flag skip_flag in inter mode may be coded using 3 contexts: context 0: left and top block are not in skip mode, context 1: top or left block (e.g., only one block) is in skip mode, context 2: top and left blocks are in skip mode.

The values of some other mode in the block may be used to compute the current context of a bin.

For CABAC coded syntax elements, bins may be encoded using model(s) that are unique for each bin. The model(s) may contain a state (e.g., representing the probability of the bin) and may be chosen using the syntax element to code and/or the context of the bin.

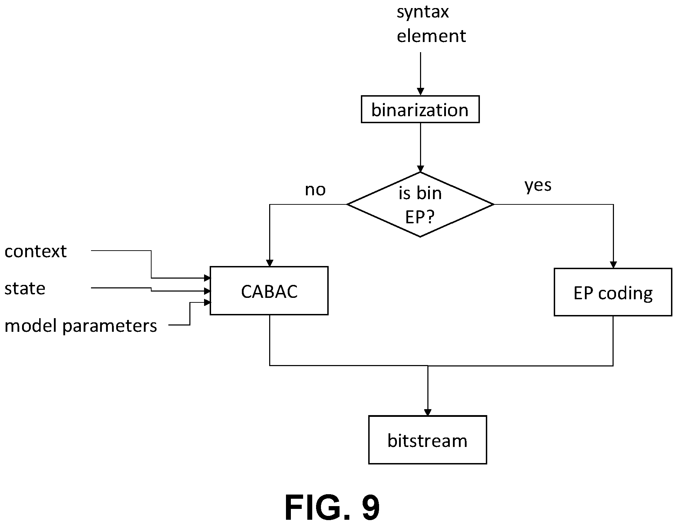

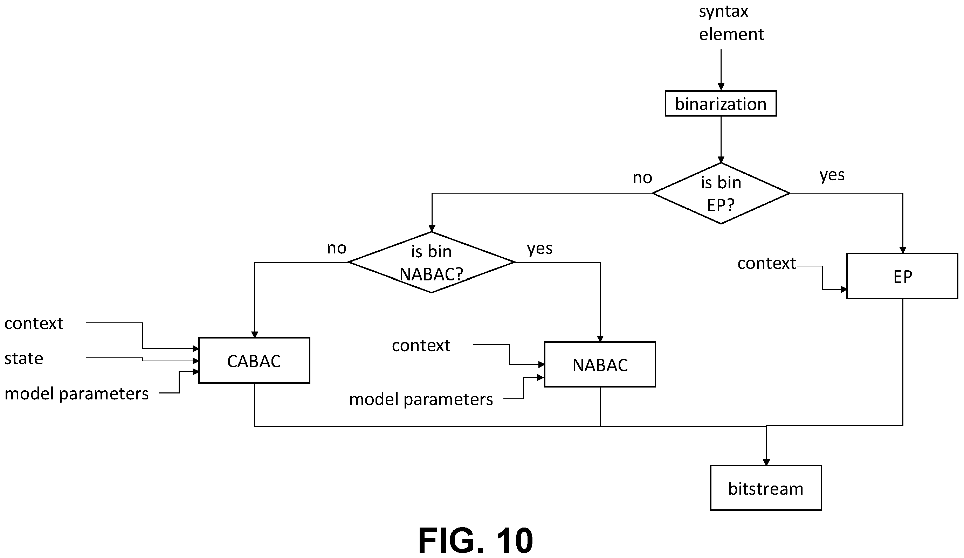

FIG. 9 depicts an example syntax element coding workflow. FIG. 10 depicts an example adapted syntax element coding workflow.

As shown in FIG. 10, a NABAC encoding may be included in the plurality of bin encoding/decoding methods. This NABAC encoding may benefit from the CABAC framework already in place. For example, the model parameters, such as the probability of the bin, may depend on the QP and the slice type (e.g., see FIG. 6). For example, the model parameters may be chosen between slice B or slice P for slice of type B or P (e.g., see FIG. 7). For example, the model parameters may be reported from one frame to another.

The 3 coding/decoding modes (e.g., CABAC, NABAC, EP) may use a context in order to identify coded bins (e.g., each coded bin). In the case of EP bin, even if the context has no impact on the encoding/decoding process, the bin may be identified because, for example, it may use a different encoding/decoding model. For example, the different encoding/-decoding may depend on the slice type and/or the profile level.

EP bins may be transformed. EP encoding may be used to encode binarized values. Values may be binarized using, for example, one or more of the following methods: exponential-golomb coding; unary coding; rice-golomb coding; or truncated binary encoding.

Exponential-Golomb coding may be used to binarize values, for example by including a prefix giving the length of the binary code to encode and the code itself.

Unary coding may be used to binarize values. For example the value N may be coded using N bits (e.g., a series of 0 and 1 to terminate).

Rice-Golomb coding may be used to binarize values.

Truncated binary encoding may be used to binarize values. For example, a binarization may be used to encode values where the total number of values is not necessarily a power of 2.

Direct binarization may be use to binarize values. For example, a value may be written on N bits using binary representation.

Unary max equiprobable may be used to binarize valyes. For example, a unary coding model with a known maximum value may be used (e.g., to avoid coding the termination bit when the value is greater or equal to the maximum value minus 1).

A bin (e.g., coming from one of the above binarization) may be associated to a context.

In examples, the previously EP coded values may use a different binarization when CABAC or NABAC is used for the particular syntax element.

Unary coding may be used to binarize values. Values binarized using unary code and encoded/decoded using unary coded may be adapted based on one or more of the following.

For a value N, for a bit of N (e.g., for each bit of N), from the LSB (e.g., least significant) to the MSB (e.g., having a value 0 by construction), a different context may be used to encode a bin (e.g., each bin).

For example, to encode the value 3, binarized as the series {1,1,1,0}, each successive bit may employ a different context. Each of these contexts may be associated with a particular syntax element.

For example, the index of the bi-prediction with CU-level weights (BCW) (e.g., an index in a table which may specify how to blend the 2 predictions of a bi-predicted block) may be encoded using unary code with EP coding.

For example, the index of the BCW may be decoded with the following loop:

```
idx=1
for(int i=0;i<maxIndex;i++) {
        if (decodeBinEP()==0) break;
        else idx++;
}
```

where idx at the end may be the decoded index, and decodeBinEP() may be the bin decoded in EP (e.g., just reading the bit 0 or 1 in the bitstream). For example, the loop may then be replaced by:

```
idx=1
for(int i=0;i<maxIndex;i++) {
        if (decodeBin(ContextBCW_i)==0) break;
        else idx++;
}
```

where ContextBCW_i is a different context for each loop step i.

Depending on the model associated with ContextBCW_i, the encoding/decoding process may be a CABAC process, a NABAC process, or an EP process.

Truncated binary coding may be used to binarize values. The truncated binary coding may use the following process to encode a value x in the interval [0-N]. The truncated binary coding may compute L=floor(log2(N)) the number of bits (minus 1 if not a power of 2) needed to encode a value in the interval. If x is below (2^(L+1)-N) then x may be encoded in binary representation using L bits, which may be referred to as A encoding. The same encoding may (e.g., otherwise) be used and an additional bit may be used to encode the values above the unused code words, which may be referred to as B encoding.

The adaptation may comprise of associating a context to a bin (e.g., each bin) of the word to encode and another one to the additional bin(s) used when the value is above the unused code words.

An exponential Golomb may be composed of a prefix code of length N, composed for example of a series of 1 terminated by a 0, and a suffix code of length N+K (e.g., where K is a known constant). The suffix code (e.g., of length N+K) may be read as suffix.

Exponential Golomb may be adapted, for example, to associate a context for each bit of the prefix (e.g., the prefix may be associated with a context) and a context for each bit of the suffix (e.g., the suffix may be associated with a context, for example a different context than that associated with the prefix). For example, for the prefix the first bit to encode may be associated with the context 0, the second bit with context 1, etc.

A video decoding method may include one or more of the following: obtaining a syntax element comprising a plurality of prefix bits associated with a plurality of contexts in a first set of contexts, and a plurality of suffix bits associated with a plurality of contexts in a second set of contexts; entropy decoding the plurality of prefix bits using a first entropy coding model based on the plurality of contexts in the first set of contexts; and entropy decoding the plurality of suffix bits using a second entropy coding model based on the plurality of contexts in the second set of contexts.

For some syntax elements, the context associated with a bin (e.g., each bin) to encode might not necessarily reflect an underlying distribution. For example, the sign of the coefficients of the residual encoding may be taken in the following. Other syntax elements associated with the encoding of a set of values where the size of the set can vary may use the described method.

In video coding, after a block have has been predicted, a residual may be computed, transformed, and/or quantized, forming a list of N values, where N is the number of samples in the block. For each non null coefficients, a sign may be encoded/decoded using EP values. The following method may be used:

For i=0 to number of signs to decode:

$$\text{sign[i]=decodeBinEP()}$$

Because the rank of the sign to encode in the block might not be suitable to describe the context, the rank may be replaced by the following context:

$$V=MAX/2$$

$$\text{For i=0 to number of signs to decode:}$$

$$\text{sign[i]=decodeBin(contextSign(V))}$$

$$\text{If sign[i] then}$$

$$V=V+1$$

$$\text{Else}$$

$$V=V-1$$

$$V=clip(0,MAX,V)$$

In this process, V may be the clipped sum of the sign (e.g., series of -1 or +1). A context may be associated with each value of V in the interval [0,MAX] (e.g., MAX=8). The function may clip the value V in the interval [0,MAX].

Direct binarization may be used to binarize values. When decoding a value v on N bits using direct binarization, the following may be used (e.g., when using EP):

$$v=0$$

$$\text{for(int i=0;i<N;i++) \{}$$

$$v=(v<<1)|\ decodeBinEP();$$

$$\}$$

In examples, the most signficiant bit (MSB) may be decoded first.

Direct binarization may be adapted (e.g., replaced) to use a context by, for example:

```
for(int i=0;i<N;i++) {

    v=(v<<1)| decodeBin(context(N-1-i));

}
```

Where context(i) may be the ith context associated with the syntax element to decode. The MSB may be associated with the context(N-1) and the least signficiant bit (LSB) may be associated with the context(0).

When encoding a syntax element for which the number of bits N required to encode the value changes depending on the context, an offset may be used (e.g., required) to have a correspondence between bit value ranks (e.g., each bit value rank) during decoding. For example, when using truncated binary code an offset may be used. For example, when using a first type of encoding (e.g., type A encoding) N bits may be used (e.g., the N most significant bits among N+1) and when using a second type of encoding (e.g., type B encoding) the context(0) may be used to encode the additional bit.

The model may be used with settings provided herein. For example, the parameters describing the model may be as follows.

3 bits may be used to encode the slope and 3 bits the offsets of the linear function used to encode the initial probability associated with a context. The slope and offsets may be used in a linear function of the QP of the slice. 2 bits + 2 bits may be used to encode the windows size w0 and w1 (e.g., 2 bits each).

For example, the following parameters may be used. 3 bits + 3 bits may be used to encode the weights associated with each probability p0 and p1 (e.g., 3 bits each). 8 bits + 8 bits may be associated with the rate offsets.

To keep the memory amount used by the models the same, the choice of the model to use (e.g., CABAC, NABAC, or EP) may be encoded, for example, in the parameters w0 and w1. The following process may be used to recover (e.g., decode) the windows size from the 2 parameters window_size0 and window_size1 which can take value in [0,3]:

$$int\ w0 = 2 + window\_size0$$

$$int\ w1 = 3 + w0 + window\_size1$$

The value w1 should not be greater than 9. Table 2 includes example allowable values for w0 and w1.

Table 2 - Example allowable window size values

| Window size 0 | Window size 1 | w0 | w1 |
|---|---|---|---|
| 0 | 0 | 2 | 5 |
| 1 | 0 | 3 | 6 |
| 2 | 0 | 4 | 7 |
| 3 | 0 | 5 | 8 |
| 0 | 1 | 2 | 6 |
| 1 | 1 | 3 | 7 |
| 2 | 1 | 4 | 8 |
| 3 | 1 | 5 | 9 |
| 0 | 2 | 2 | 7 |
| 1 | 2 | 3 | 8 |
| 2 | 2 | 4 | 9 |
| 3 | 2 | 5 | X |
| 0 | 3 | 2 | 8 |
| 1 | 3 | 3 | 9 |
| 2 | 3 | 4 | X |
| 3 | 3 | 5 | X |

The pair of parameters (3,2), (2,3) and (3,3) may not be allowed for window size 0 and widow size 1 (e.g., based on the mapping in Table 1). In examples, these pair values may be used to encode the model selection between CABAC, NABAC and EP, for example as represented in Table 3.

Table 3 - Example allowable window size values

| Window size 0 | Window size 1 | w0 | w1 |
|---|---|---|---|
| 0 | 0 | 2 | 5 |
| 1 | 0 | 3 | 6 |
| 2 | 0 | 4 | 7 |
| 3 | 0 | 5 | 8 |
| 0 | 1 | 2 | 6 |
| 1 | 1 | 3 | 7 |
| 2 | 1 | 4 | 8 |
| 3 | 1 | 5 | 9 |
| 0 | 2 | 2 | 7 |
| 1 | 2 | 3 | 8 |
| 2 | 2 | 4 | 9 |
| 3 | 2 | 5 | X |
| 0 | 3 | 2 | 8 |
| 1 | 3 | 3 | 9 |
| 2 | 3 | 4 | EP model |
| 3 | 3 | 5 | NABAC model |

In examples, disallowed values to encode the weighting between state0 and state1 (p0 and p1) may be used. The weighting values may be encoded on 3 bits, allowing values in [0,7]. In some examples, 5 values (e.g., only 5 values encoded with the 3 bits) may be used. The values above 5 may be used to select model NABAC or EP for example.

In examples, some values of the rate offsets may be reserved to encode the selection of the model between NABAC and EP (e.g., with other values being used for CABAC model).

Model selection may be performed based on a context associated with a bin (e.g., each bin). A bin (e.g., each bin or a subset of a bin) may uses the same encoding/decoding process. The bin may be (e.g., may always be) associated with a context. The context may correspond to a model, for example with associated model parameters. The model parameters may be used to decide which model to use (e.g., among CABAC, NABAC or EP). The bin may be encoded/decoded according to the model that corresponds to its associated context.

Training may be performed to tune the parameters of a bin (e.g., each bin). Training may be performed offline. The results of the training may be fixed and known (e.g., configured, preconfigured) in the encoder and the decoder. In examples, the result of the training strategy may be transmitted to the decoder (e.g., before decoding the bitstream). Training may include one or more of the following.

A set (e.g., (pre)configured) dataset of video sequences may be encoded using a default model for a bin (e.g., each bin). The default model may, for example, be the model parameters of a previous model parameters tuning. Some of the bins may, for example, use the EP encoding. The context may be clearly identified during the decoding process.

The resulting bitstream may be decoded and, for each context (e.g., which may be clearly identified during the decoding process), the series of bins (0 or 1) may be dumped, for a slice (e.g., each slice) of a frame (e.g., each frame) or a sequence (e.g., each sequence).

During a training stage, each context and the associated model parameters may be tuned to minimize a cost function (e.g., the total cost of the encoded bits, the ratio of bit(s) cost to the bitstream size etc.). The tuning of the parameters may comprise one or more of choosing among the encoding modes (e.g., CABAC, NABAC or EP); tuning the parameters related to the initial probability (e.g., for CABAC and/or NABAC); or tuning other parameters (e.g., window sizes, weight between state 0 and 1, rate offsets for CABAC).

The training (e.g., as described above) may be repeated (e.g., several times). The optimal parameters obtained this way may be used to encode the dataset of video sequences and the training stage may be performed again. In examples, the number of training epochs may be fixed (e.g., 2 or 3 steps may attain optimal results). In exampels, training may stop after the coding gain between one epoch and the next epoch drops below a certain value.

After this training stage, the resulting model parameters may be used to encode/decode the bins (e.g., each bin).

Training may be modified based on profile and/or constraints. For example, depending on the decoder capabilities, some constraints may be applied on the maximum number of CABAC coded bins to decode a slice. In account for these constraints, the training strategy may be changed, for example with one or more of the following.

For a context (e.g., each context) to tune, the associated ratio of the total number of bits for the context may be divided by the sum of the total number of bits is used:

$$r_i = \frac{\sum_{all\ slice,all\ sequences} number\ of\ bits\ for\ context\ i}{\sum_{j\ for\ all\ contexts} \sum_{all\ slice,all\ sequences} number\ of\ bits\ for\ context\ j}$$

In examples, the ratio may depict the average ratio for slices (e.g., all slices) in the dataset:

$$r_i = \frac{1}{total\ number\ of\ slices\ for\ all\ sequences} \sum_{all\ slice,all\ sequences} \frac{number\ of\ bits\ for\ context\ i}{\sum_{j\ for\ all\ contexts} number\ of\ bits\ for\ context\ j}$$

For a context (e.g., each context) to tune, one of more of the following may be computed: the optimal parameters using CABAC model, the optimal model using the NABAC/EP model, and/or the cost function value for a model (e.g., each model). If the best model overall is NABAC or EP, the CABAC model may be noted as invalid.

Given a constraint of ratio of maximum number of CABAC coded bits, the following optimization may be performed (e.g., such that the ration of CABAC coded bits may be below the contraint):

$$\arg \min_{m_i\ in\ [C,N]} \sum_{all\ context\ i} cost(m_i)$$

where $m_i$ may be C or N (e.g., the model for context i may be CABAC or NABAC/EP) and $cost(m_i)$ may be the model $m_i$ for context i.

In examples, additional constraint(s) on the maximum number of bits using the NABAC model may be used.

In examples, a constraint on the model to use may be set by syntax elements (e.g., instead of individual bins). For example, the bits of a binarized syntax element may use the same model type.

Table 4 below shows an example of results of such optimization.

Table 4 - Example results of optimization

| Context | Bits coding profile 0 (No constraint) | Bits coding profile 1 (At most constraint 50% of the bits are CABAC coded) | Bits coding profile 2 (At most constraint 70% of the bits are CABAC coded) |
|---|---|---|---|
| 0 | CABAC model | CABAC model | CABAC model |
| 1 | CABAC model | NABAC | EP |
| 2 | CABAC model | CABAC model | NABAC |
| 3 | CABAC model | CABAC model | CABAC model |

The resulting training may be used to choose between different profiles of bitstream.

For example, a coding profile indication may be signaled in the Sequence Parameters Set (sps):

| seq_parameter_set_rbsp( ) { | Descriptor |
|---|---|
| ...... | |
| **bits_coding_profile** | ae(v) |
| ...... | |

(continued)

| | |
|---|---|
| } | |

The decoded value for the bits_coding_profile syntax element may be used to select the set of models used to decode the bits associated with each context. In previous table example, the value of bits_coding_profile can take value in [0,2] depending on the desired constraints.

Although features and elements are described above in particular combinations, one of ordinary skill in the art will appreciate that each feature or element can be used alone or in any combination with the other features and elements. In addition, the methods described herein may be implemented in a computer program, software, or firmware incorporated in a computer-readable medium for execution by a computer or processor. Examples of computer-readable media include electronic signals (transmitted over wired or wireless connections) and computer-readable storage media. Examples of computer-readable storage media include, but are not limited to, a read only memory (ROM), a random access memory (RAM), a register, cache memory, semiconductor memory devices, magnetic media such as internal hard disks and removable disks, magneto-optical media, and optical media such as CD-ROM disks, and digital versatile disks (DVDs). A processor in association with software may be used to implement a radio frequency transceiver for use in a WTRU, UE, terminal, base station, RNC, or any host computer.

**Claims**

1. A video decoding method, comprising:

   obtaining a syntax element comprising a plurality of bits coded in a plurality of corresponding bins;
   determining a bit count in the syntax element;
   determining a context associated with a most significant bit (MSB) of the syntax element based on the bit count; and
   entropy decoding the syntax element based on the determined context associated with the MSB.

2. The method of claim 1, wherein each of the plurality of bins is associated with a respective context of a plurality of contexts associated with the syntax element, and identifying the context associated with the MSB of the syntax element further comprises:

   identifying, based on the bit count in the syntax element, a last context of the plurality of contexts; and
   associating the last context of the plurality of contexts with the MSB of the syntax element.

3. The method of claim 2, wherein entropy decoding the syntax element based on the identified context associated with the MSB further comprises:
   entropy decoding a bin corresponding to the MSB of the syntax element based on the identified context associated with the MSB.

4. The method of claim 3, wherein each of the plurality of bins is associated with a respective context of a plurality of contexts associated with the syntax element, and the method further comprises:

   identifying, based on the bit count in the syntax element, a second-to-last context of the plurality of contexts;
   associating the second-to-last context of the plurality of contexts with a second MSB of the syntax element; and
   entropy decoding a bin corresponding to the second MSB of the syntax element based on the identified second-to-last context associated with the second MSB of the syntax element.

5. The method of claim 1, wherein each of the plurality of bins is associated with a respective context of a plurality of contexts associated with the syntax element, and the method further comprises:

   identifying a first context of the plurality of contexts;
   associating the first context of the plurality of contexts with a least significant bit (LSB) of the syntax element; and
   entropy decoding a bin corresponding to the LSB of the syntax element based on the identified first context associated with the LSB of the syntax element.

6. The method of claim 1, further comprising determining, based on the context associated with the MSB, an entropy coding model for decoding the MSB of the syntax element, wherein the entropy coding model is at least one of context adaptive binary arithmetic coding (CABAC), non-adaptive binary arithmetic coding (NABAC), or context adaptive equal probability coding.

7. The method of claim 1, wherein each of the plurality of bins is associated with a respective context of a plurality of contexts associated with the syntax element, wherein the syntax element comprises an additional bit associated with truncated binarization and the method further comprises:

identifying a first context of the plurality of contexts;
associating the first context of the plurality of contexts with the additional bit; and
entropy decoding a bin corresponding to the additional bit based on the identified first context associated with the additional bit.

8. A video encoding method, comprising:

determining a syntax element, wherein the syntax element having a plurality of bits;
determining, for each bit in the syntax element, an associated context; and
entropy encoding, based on the context associated with each bit in the plurality of bits, the syntax element in a plurality of bins.

9. The method of claim 8, wherein a context associated with a most significant bit (MSB) is associated with an entropy coding model used for encoding the syntax element.

10. The method of claim 8, wherein the entropy coding model is at least one of context adaptive binary arithmetic coding (CABAC), non-adaptive binary arithmetic coding (NABAC) or context adaptive equal probability coding.

11. The method of claim 8, wherein the number of bits comprises a prefix associated with a first portion of the number of bits and a first context, and a suffix code associated with a second portion of the number of bits and a second context.

12. A video decoding device comprising a processor configured to perform the method of any one of claims 1-7.

13. A video encoding device comprising a processor configured to perform the method of any one of claims 8-11.

14. A computer program comprising program code instructions for implementing the method according to any one of claims 1-11 when executed by a processor.

15. Video data comprising information representative of the syntax element encoded according to the method of any one of claims 8-11.

FIG. 1A

**FIG. 1B**

**FIG. 1C**

**FIG. 1D**

EP 4 614 973 A1

**FIG. 2**

**300**

**FIG. 3**

EP 4 614 973 A1

FIG. 4

FIG. 5

Slice type

qp

Get slope and offset

Compute Initial
probability:
p=slope*qp+offset

get windows size:
w0
w1

# FIG. 6

EP 4 614 973 A1

**FIG. 7**

DecodeDecision(ctxTable, ctxIdx)

qRangeIdx = ivlCurrRange >> 5
pState = pStateIdx1 + 16 * pStateIdx0
valMps = pState >> 14
ivlLpsRange = ( qRangeIdx * ( (valMps ? 32767 ? pState : pState ) >> 9 ) >> 1 ) + 4
ivlCurrRange = ivlCurrRange − ivlLpsRange

ivlOffset >= ivlCurrRange?

Yes

No

binVal = !valMps
ivlOffset = ivlOffset − ivlCurrRange
ivlCurrRange = ivlLpsRange

binVal = valMps

shift0 = (shiftIdx >> 2) + 2
shift1 = (shiftIdx & 3) + 3 + shift0
pStateIdx0 = pStateIdx0 − (pStateIdx0 >> shift0) + (1023 * binVal >> shift0)
pStateIdx1 = pStateIdx1 − (pStateIdx1 >> shift1) + (16383 * binVal >> shift1)

RenormD

Done

# FIG. 8

**FIG. 9**

**FIG. 10**

EP 4 614 973 A1

Europäisches
Patentamt

European
Patent Office

Office européen
des brevets

# EUROPEAN SEARCH REPORT

**Application Number**

EP 24 30 5345

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | MARPE D ET AL: "VIDEO COMPRESSION USING CONTEXT-BASED ADAPTIVE ARITHMETIC CODING", PROCEEDINGS 2001 INTERNATIONAL CONFERENCE ON IMAGE PROCESSING. ICIP 2001 - THESSALONIKI, GREECE, OCT. 7 - 10, 2001; [INTERNATIONAL CONFERENCE ON IMAGE PROCESSING], INSTITUTE OF ELECTRICAL AND ELECTRONICS ENGINEERS, NEW YORK, NY, vol. 3, 7 October 2001 (2001-10-07), pages 558-561, XP001086520, DOI: 10.1109/ICIP.2001.958175 ISBN: 978-0-7803-6725-8 * the whole document * | 1-15 | INV. H04N19/13 H03M7/40 H04N19/184 H04N19/91 |
| X | US 2004/101205 A1 (DHAVALA SOMASEKHAR [IN] ET AL) 27 May 2004 (2004-05-27) * paragraph [0018] * | 1,8, 11-15 | |
| X | BROSS B ET AL: "High Efficiency Video Coding (HEVC) text specification draft 6", 8. JCT-VC MEETING; 20120201 - 20120210; SAN JOSE; (JOINT COLLABORATIVE TEAM ON VIDEO CODING OF ISO/IEC JTC1/SC29/WG11 AND ITU-T SG.16 ), , no. JCTVC-H1003 14 February 2012 (2012-02-14), XP030232941, Retrieved from the Internet: URL:http://phenix.int-evry.fr/jct/doc_end_ user/documents/8_San%20Jose/wg11/JCTVC-H10 03-v16.zip JCTVC-H1003_dF.doc [retrieved on 2012-02-14] * paragraph [9.2.2]; tables 9-32 * | 1-15 | |

**TECHNICAL FIELDS SEARCHED (IPC)**

H04N
H03M

The present search report has been drawn up for all claims

| Place of search | Date of completion of the search | Examiner |
|---|---|---|
| Munich | 24 July 2024 | Oelbaum, Tobias |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 24 30 5345

This annex lists the patent family members relating to the patent documents cited in the above-mentioned European search report.
The members are as contained in the European Patent Office EDP file on
The European Patent Office is in no way liable for these particulars which are merely given for the purpose of information.

24-07-2024

| Patent document cited in search report | Publication date | Patent family member(s) | Publication date |
|---|---|---|---|
| US 2004101205 A1 | 27-05-2004 | NONE | |

EPO FORM P0459

For more details about this annex : see Official Journal of the European Patent Office, No. 12/82